(19) Europäisches Patentamt
European Patent Office
Office européen des brevets

(11) **EP 4 657 529 A1**

(12) **EUROPEAN PATENT APPLICATION**
published in accordance with Art. 153(4) EPC

(43) Date of publication:
**03.12.2025 Bulletin 2025/49**

(21) Application number: **23918590.3**

(22) Date of filing: **13.12.2023**

(51) International Patent Classification (IPC):
**H01L 27/146** (2006.01)    **H04N 25/70** (2023.01)
**H04N 25/704** (2023.01)

(52) Cooperative Patent Classification (CPC):
**H04N 25/70; H04N 25/704; H10F 39/12**

(86) International application number:
**PCT/JP2023/044598**

(87) International publication number:
**WO 2024/157635 (02.08.2024 Gazette 2024/31)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **23.01.2023 JP 2023008068**

(71) Applicant: **Sony Semiconductor Solutions
Corporation
Atsugi-shi, Kanagawa 243-0014 (JP)**

(72) Inventors:
• **TAMURA, Syuto
Atsugi-shi, Kanagawa 243-0014 (JP)**
• **TOGASHI, Hideaki
Atsugi-shi, Kanagawa 243-0014 (JP)**
• **OHKUBO, Tomohiro
Atsugi-shi, Kanagawa 243-0014 (JP)**
• **KAWAI, Nobuhiro
Atsugi-shi, Kanagawa 243-0014 (JP)**

(74) Representative: **Müller Hoffmann & Partner
Patentanwälte mbB
St.-Martin-Strasse 64
81541 München (DE)**

(54) **LIGHT DETECTION DEVICE AND ELECTRONIC EQUIPMENT**

(57)    A photodetection device includes a photoelectric conversion layer and a color splitter layer. The photoelectric conversion layer includes a photoelectric conversion section group configured by a plurality of photoelectric conversion sections capable of detecting phase differences among incident light beams made incident thereon. The color splitter layer is located further on a light incident side than the photoelectric conversion layer and has a meta-surface structure.

FIG.2

## Description

Field

The present disclosure relates to a photodetection device and electronic equipment.

Background

In recent years, there has been proposed a stacked image sensor in which a plurality of photoelectric conversion elements are stacked in a light incident direction. For example, there has been proposed a solid-state imaging element in which a photoelectric conversion section that photoelectrically converts light in one wavelength region is provided on a light incident side and a photoelectric conversion section that photoelectrically converts light in another wavelength region is provided on a side opposite to the light incident side (see, for example, Patent Literature 1.).

Citation List

Patent Literature

Patent Literature 1: JP 2017-157801 A

Summary

Technical Problem

However, in the related art explained above, since the stacked respective photoelectric conversion sections cannot be simultaneously focused, there is a problem in that, when it is attempted to detect a phase difference in the photoelectric conversion section out of focus, detection sensitivity of the phase difference decreases.
Therefore, the present disclosure proposes a photodetection device and electronic equipment that can improve detection sensitivity of a phase difference.

Solution to Problem

According to the present disclosure, there is provided a photodetection device. The photodetection device includes a photoelectric conversion layer and a color splitter layer. The photoelectric conversion layer includes a photoelectric conversion section group configured by a plurality of photoelectric conversion sections capable of detecting phase differences among incident light beams made incident thereon. The color splitter layer is located further on a light incident side than the photoelectric conversion layer and has a meta-surface structure.

Brief Description of Drawings

FIG. 1 is a system configuration diagram illustrating a schematic configuration example of a photodetection device according to embodiments of the present disclosure.
FIG. 2 is a cross-sectional view schematically illustrating a structure of a pixel region according to a first embodiment of the present disclosure.
FIG. 3 is a diagram for explaining a stacked structure and a planar structure of the pixel region according to the first embodiment of the present disclosure.
FIG. 4 is a diagram for explaining a principle of a color splitter according to the embodiments of the present disclosure.
FIG. 5 is a diagram illustrating an incident state of green light in the pixel region according to the first embodiment of the present disclosure.
FIG. 6 is a diagram illustrating an incident state of red light in the pixel region according to the first embodiment of the present disclosure.
FIG. 7 is a diagram illustrating an incident state of blue light in the pixel region according to the first embodiment of the present disclosure.
FIG. 8 is a diagram for explaining a stacked structure and a planar structure of a pixel region according to a modification 1 of the first embodiment of the present disclosure.
FIG. 9 is a diagram for explaining a stacked structure and a planar structure of a pixel region according to a modification 2 of the first embodiment of the present disclosure.

FIG. 10 is a diagram for explaining a stacked structure and a planar structure of a pixel region according to a modification 3 of the first embodiment of the present disclosure.

FIG. 11 is a cross-sectional view schematically illustrating a structure of a pixel region according to a modification 4 of the first embodiment of the present disclosure.

FIG. 12 is a diagram for explaining a stacked structure and a planar structure of the pixel region according to the modification 4 of the first embodiment of the present disclosure.

FIG. 13 is a diagram for explaining a stacked structure and a planar structure of a pixel region according to a modification 5 of the first embodiment of the present disclosure.

FIG. 14 is a diagram for explaining a stacked structure and a planar structure of a pixel region according to a modification 6 of the first embodiment of the present disclosure.

FIG. 15 is a diagram for explaining a stacked structure and a planar structure of a pixel region according to a modification 7 of the first embodiment of the present disclosure.

FIG. 16 is a cross-sectional view schematically illustrating a structure of a pixel region according to a second embodiment of the present disclosure.

FIG. 17 is a diagram for explaining a stacked structure and a planar structure of the pixel region according to the second embodiment of the present disclosure.

FIG. 18 is a diagram for explaining a stacked structure and a planar structure of a pixel region according to a modification 1 of the second embodiment of the present disclosure.

FIG. 19 is a diagram for explaining a stacked structure and a planar structure of a pixel region according to a modification 2 of the second embodiment of the present disclosure.

FIG. 20 is a diagram for explaining a stacked structure and a planar structure of a pixel region according to a modification 3 of the second embodiment of the present disclosure.

FIG. 21 is a cross-sectional view schematically illustrating a structure of a pixel region according to a modification 4 of the second embodiment of the present disclosure.

FIG. 22 is a diagram for explaining a stacked structure and a planar structure of the pixel region according to the modification 4 of the second embodiment of the present disclosure.

FIG. 23 is a cross-sectional view schematically illustrating a structure of a pixel region according to a modification 5 of the second embodiment of the present disclosure.

FIG. 24 is a diagram for explaining a stacked structure and a planar structure of the pixel region according to the modification 5 of the second embodiment of the present disclosure.

FIG. 25 is a diagram for explaining a stacked structure and a planar structure of a pixel region according to a modification 6 of the second embodiment of the present disclosure.

FIG. 26 is a diagram for explaining a stacked structure and a planar structure of a pixel region according to a modification 7 of the second embodiment of the present disclosure.

FIG. 27 is a diagram for explaining a stacked structure and a planar structure of a pixel region according to a modification 8 of the second embodiment of the present disclosure.

FIG. 28 is a cross-sectional view schematically illustrating a structure of a pixel region according to a modification 9 of the second embodiment of the present disclosure.

FIG. 29 is a diagram for explaining a stacked structure and a planar structure of the pixel region according to the modification 9 of the second embodiment of the present disclosure.

FIG. 30 is a diagram for explaining a stacked structure and a planar structure of a pixel region according to a third embodiment of the present disclosure.

FIG. 31 is a diagram for explaining a stacked structure and a planar structure of a pixel region according to a modification 1 of the third embodiment of the present disclosure.

FIG. 32 is a diagram for explaining a stacked structure and a planar structure of a pixel region according to a modification 2 of the third embodiment of the present disclosure.

FIG. 33 is a cross-sectional view schematically illustrating a structure of a pixel region according to a fourth embodiment of the present disclosure.

FIG. 34 is a diagram for explaining a stacked structure and a planar structure of a pixel region according to a fourth embodiment of the present disclosure.

FIG. 35 is a block diagram illustrating a configuration example of electronic equipment.

FIG. 36 is a block diagram depicting an example of schematic configuration of a vehicle control system.

FIG. 37 is a diagram of assistance in explaining an example of installation positions of an outside-vehicle information detecting section and an imaging section.

FIG. 38 is a view depicting an example of a schematic configuration of an endoscopic surgery system.

FIG. 39 a block diagram depicting an example of a functional configuration of a camera head and a camera control unit (CCU).

Description of Embodiments

Embodiments of the present disclosure are explained in detail below with reference to the drawings. Note that, in the embodiments explained below, redundant explanation is omitted by denoting the same parts with the same reference numerals and signs.

In recent years, there has been proposed a stacked image sensor in which a plurality of photoelectric conversion elements are stacked in a light incident direction. For example, there has been proposed a solid-state imaging element in which a photoelectric conversion section that photoelectrically converts light in one wavelength region is provided on a light incident side and a photoelectric conversion section that photoelectrically converts light in another wavelength region is provided on a side opposite to the light incident side.

However, in the related art explained above, since the stacked respective photoelectric conversion sections cannot be simultaneously focused, there is a problem in that, when it is attempted to detect a phase difference in the photoelectric conversion section out of focus, detection sensitivity of the phase difference decreases.

Therefore, it is expected to implement a technology that can overcome the problems explained above and improve the detection sensitivity of the phase difference in the photodetection device.

[Configuration of a photodetection device]

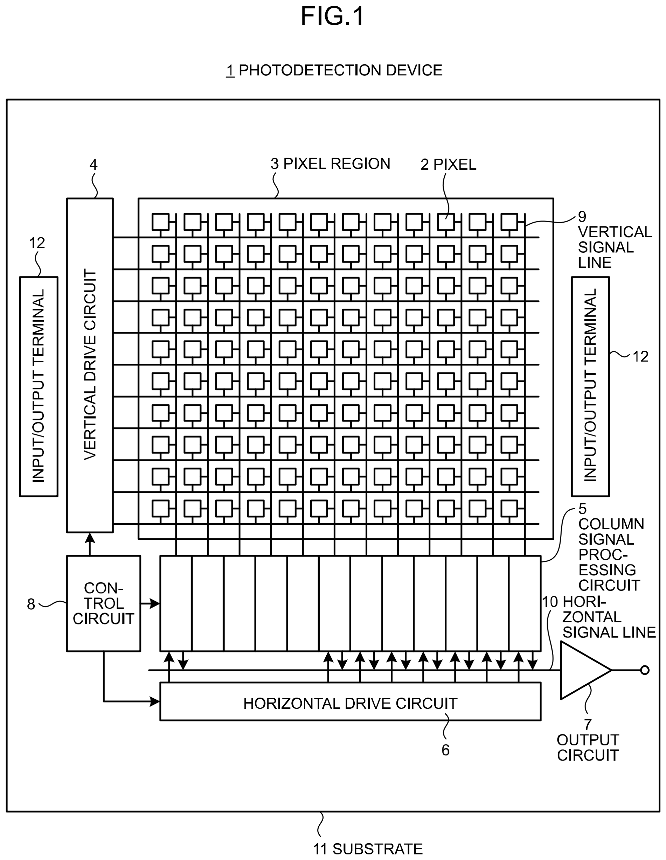

FIG. 1 is a diagram illustrating a configuration example of a photodetection device 1 according to the embodiments of the present disclosure. As illustrated in FIG. 1, the photodetection device 1 of the present example includes a pixel region 3 and a peripheral circuit section. The pixel region 3 is a so-called imaging region where pixels 2 including a plurality of photoelectric conversion elements are regularly and two-dimensionally arrayed on a semiconductor substrate 11, for example, a silicon substrate.

The pixel 2 includes a photoelectric conversion element, for example, a photodiode, and a plurality of pixel transistors (so-called MOS transistors). The plurality of pixel transistors can include, for example, three transistors of a transfer transistor (a charge transfer section explained below), a reset transistor, and an amplifier transistor.

The plurality of pixel transistors can also be configured by four transistors by adding a selection transistor. The pixels 2 can also have a shared pixel structure. This pixel sharing structure is configured from a plurality of photodiodes, a plurality of transfer transistors, shared one floating diffusion region, and shared each one another pixel transistor.

The peripheral circuit section includes a vertical drive circuit 4, a column signal processing circuit 5, a horizontal drive circuit 6, an output circuit 7, and a control circuit 8. The control circuit 8 receives an input clock and data instructing an operation mode or the like and outputs data such as internal information of the photodetection device 1.

That is, the control circuit 8 generates, based on a vertical synchronization signal, a horizontal synchronization signal, and a master clock, a clock signal or a control signal serving as references of operations of the vertical drive circuit 4, the column signal processing circuit 5, the horizontal drive circuit 6, and the like. Then, the control circuit 8 inputs these signals to the vertical drive circuit 4, the column signal processing circuit 5, the horizontal drive circuit 6, and the like.

The vertical drive circuit 4 is configured by, for example, a shift register and selects a pixel drive wire 13, supplies a pulse for driving pixels to the selected pixel drive wire, and drives the pixels in units of rows.

That is, the vertical drive circuit 4 selectively scans the pixels 2 in the pixel regions 3 sequentially in the vertical direction in units of rows. Then, the vertical drive circuit 4 supplies a pixel signal based on a signal charge generated according to a received light amount in, for example, photodiodes serving as photoelectric conversion elements of the pixels 2 to the column signal processing circuit 5 through a vertical signal line 9.

The column signal processing circuit 5 is arranged, for example, for each column of the pixels 2 and performs, for each pixel column, signal processing such as noise removal on signals output from the pixels 2 for one row.

That is, the column signal processing circuit 5 performs signal processing such as CDS (Correlated Double Sampling) for removing fixed pattern noise specific to the pixels 2, signal amplification, and AD conversion. A horizontal selection switch (not illustrated) is connected and provided between an output stage of the column signal processing circuit 5 and a horizontal signal line 10.

The horizontal drive circuit 6 is configured by, for example, a shift register and selects each of the column signal processing circuits 5 in order by sequentially outputting horizontal scanning pulses and causes each of the column signal processing circuits 5 to output a pixel signal to the horizontal signal line 10.

The output circuit 7 performs signal processing on the signals sequentially supplied from each of the column signal processing circuits 5 through the horizontal signal line 10 and outputs the processed signals. In this signal processing, for example, only buffering is sometimes performed or black level adjustment, column variation correction, various kinds of digital signal processing, and the like are sometimes performed. An input/output terminal 12 exchanges signals with the outside.

[First Embodiment]

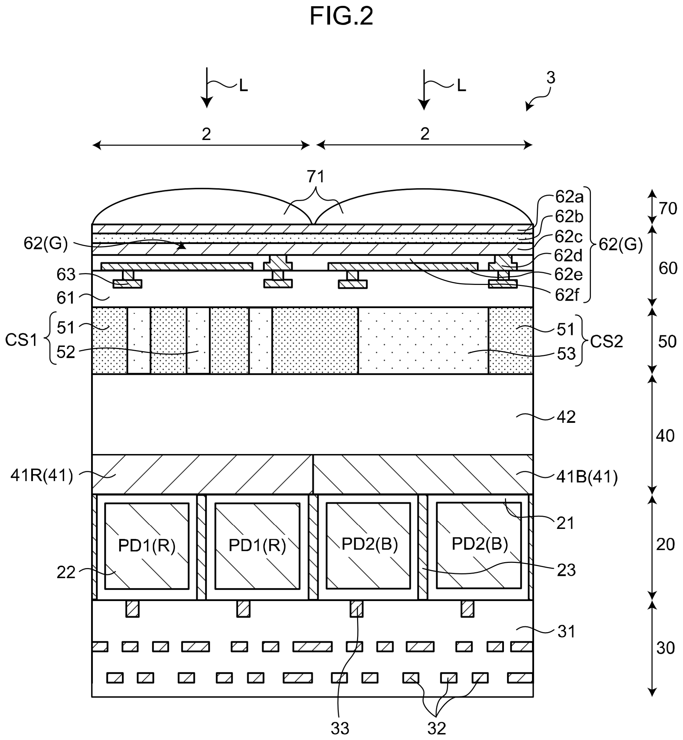

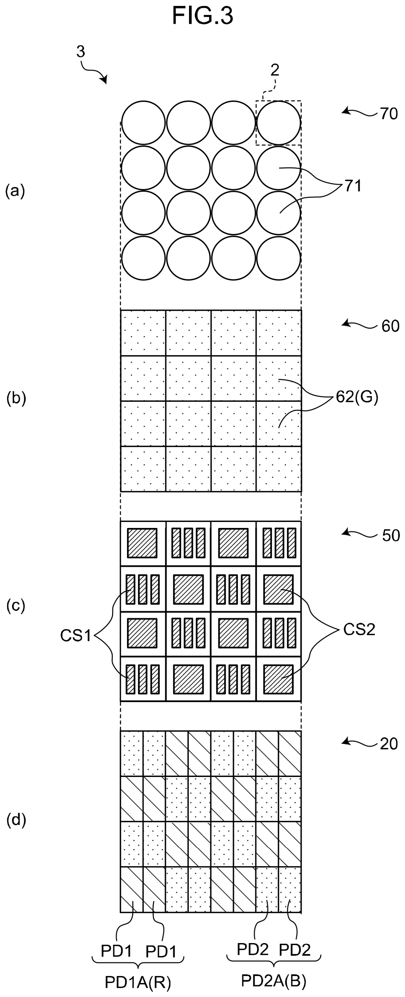

Subsequently, a detailed configuration of the pixel region 3 according to a first embodiment is explained with reference to FIG. 2 to FIG. 7. FIG. 2 is a cross-sectional view schematically illustrating a structure of the pixel region 3 according to the first embodiment of the present disclosure. FIG. 3 is a diagram for explaining a stacked structure and a planar structure of the pixel region 3 according to the first embodiment of the present disclosure.

Note that, in FIG. 3 and the following drawings similar to FIG. 3, in order to facilitate understanding, the same hatching is added to a photoelectric conversion section and a photodiode that receive light in the same wavelength region. In FIG. 3 the following drawings similar to FIG. 3, (a), (b), (c), and (d) are described in order from a side on which incident light L from the outside is made incident (hereinafter also referred to as light incident side or immediately above).

The pixel region 3 includes a semiconductor layer 20, a wiring layer 30, an optical layer 40, a color splitter layer 50, an organic photoelectric conversion layer 60, and an OCL (on chip lens) layer 70. The semiconductor layer 20 is an example of a photoelectric conversion layer. The organic photoelectric conversion layer 60 is an example of another photoelectric conversion layer.

In the pixel region 3, then OCL layer 70, the organic photoelectric conversion layer 60, the color splitter layer 50, the optical layer 40, the semiconductor layer 20, and the wiring layer 30 are stacked in order from the light incident side.

The semiconductor layer 20 includes a semiconductor region 21 of a first conductivity type (for example, P-type), a semiconductor region 22 of a second conductivity type (for example, N-type), and a separation section 23. In the semiconductor region 21 of the first conductivity type, the semiconductor regions 22 of the second conductivity type are formed side by side in a plane direction (an array direction of the pixels 2) in units of pixels, whereby photodiodes PD1 and PD2 by PN junction are formed side by side in the plane direction.

The photodiode PD1 is an example of a first photoelectric conversion section and the photodiode PD2 is an example of a second photoelectric conversion section.

For example, the photodiode PD1 is a photoelectric conversion section that receives and photoelectrically converts light in a red wavelength region (hereinafter also referred to as a "red region"). The red wavelength region (the red region) is an example of a first wavelength region.

The photodiode PD2 is a photoelectric conversion section that receives and photoelectrically converts light in a blue wavelength region (hereinafter also referred to as a "blue region".). The blue wavelength region (the blue region) is an example of a second wavelength region.

Note that, in the drawings of the present disclosure, to facilitate understanding, (R) is described in a reference sign or the like of a photodiode or a photoelectric conversion section that receives light in the red region and (B) is described in a reference sign or the like of a photodiode or a photoelectric conversion section that receives light in the blue region.

In the drawings of the present disclosure, (G) is described in a reference sign or the like of a photodiode or a photoelectric conversion section that receives light in a green region and (IR) is described in a reference sign or the like of a photodiode or a photoelectric conversion section that receives light in an infrared region.

In the first embodiment, as illustrated in (d) of FIG. 3, a photodiode group PD1A is configured by two photodiodes PD1 adjacent to each other and a photodiode group PD2A is configured by two photodiodes PD2 adjacent to each other. The photodiode groups PD1A and PD2A are an example of a photoelectric conversion section group.

In the semiconductor layer 20, for example, a plurality of photodiode groups PD1A and a plurality of photodiode groups PD2A are disposed side by side in a checkered pattern. The photodiode group PD1A or the photodiode group PD2A is, for example, individually formed for each of pixels 2 (see FIG. 2) in the pixel region 3.

FIG. 2 is referred back. The separation section 23 of the semiconductor layer 20 electrically and optically separates the photodiodes PD1 adjacent to each other, the photodiodes PD1 and PD2 adjacent to each other, and the photodiodes PD2 adjacent to each other.

Note that, in the present disclosure, the photodiodes PD1 belonging to the same photodiode group PD1A may be electrically connected by an inter-same-color path (hereinafter also referred to as overflow path) for allowing carriers to escape to another pixel when one pixel is saturated. Similarly, in the present disclosure, the photodiodes PD2 belonging to the same photodiode group PD2A may be electrically connected by an overflow path.

The separation section 23 is made of, for example, a material including an oxide film such as a silicon oxide film, a silicon nitride film, amorphous silicon, polycrystalline silicon, a titanium oxide film, aluminum, or tungsten or a metal film.

The wiring layer 30 is disposed on the surface of the semiconductor layer 20 opposite to the light incident side (hereinafter also referred to as back side or immediately below). The wiring layer 30 is configured by forming a plurality of wiring films 32 and a plurality of pixel transistors 33 in a interlayer insulating film 31. The plurality of pixel transistors 33 perform reading of charges accumulated in the photodiodes PD1 and PD2 and a photoelectric conversion section 62 explained below, and the like.

The optical layer 40 is disposed on the surface on the light incident side in the semiconductor layer 20. The optical layer 40 includes a color filter 41 and a buffer layer 42. In the optical layer 40, the color filter 41 and the buffer layer 42 are stacked in order from the light incident side.

The color filter 41 is an optical filter that transmits light in a predetermined wavelength region in the incident light L. The color filter 41 includes, for example, a color filter 41R that transmits light in the red region and a color filter 41B that transmits light in the blue region.

The color filter 41R is disposed on the light incident side of the photodiode group PD1A (see FIG. 3). The color filter 41B is disposed on the light incident side of the photodiode group PD2A (see FIG. 3). The color filter 41R or the color filter 41B is, for example, individually formed for each of the pixels 2 in the pixel region 3.

Note that a planarization layer (not illustrated) for planarizing a surface on which color filter 41 is formed and avoiding unevenness that occurs in a rotational application process in forming color filter 41 may be provided between the semiconductor layer 20 and the color filter 41.

The buffer layer 42 is provided to adjust focal lengths of the color splitters CS1 and CS2 located in the color splitter layer 50 explained below. The buffer layer 42 is made of, for example, silicon oxide and has thickness of approximately 1 ($\mu$m) to 3 ($\mu$m).

The color splitter layer 50 is disposed on the surface on the light incident side in the optical layer 40. The color splitter layer 50 includes a low refractive index section 51 and high refractive index sections 52 and 53.

The low refractive index section 51 is made of a material having a refractive index lower than those of the high refractive index sections 52 and 53. The low refractive index section 51 is made of, for example, a metal oxide such as silicon oxide or aluminum oxide or an organic substance such as acrylic resin.

The high refractive index sections 52 and 53 are made of a material having a refractive index higher than that of the low refractive index section 51. The high refractive index sections 52 and 53 are made of, for example, a silicon compound such as silicon nitride or silicon carbide, a metal oxide such as titanium oxide, tantalum oxide, niobium oxide, hafnium oxide, indium oxide, or tin oxide, or a composite oxide thereof. The high refractive index sections 52 and 53 may be made of an organic substance such as siloxane.

The high refractive index section 52 has a predetermined planar shape on the inside of the color splitter layer 50 and is disposed on the light incident side of the photodiode group PD1A. On the light incident side of the photodiode group PD1A, a color splitter CS1 is configured by the low refractive index section 51 and the high refractive index section 52.

The high refractive index section 53 has a predetermined planar shape on the inside of the color splitter layer 50 and is disposed on the light incident side of the photodiode group PD2A. On the light incident side of the photodiode group PD2A, a color splitter CS2 is configured by the low refractive index section 51 and the high refractive index section 53.

In the color splitter layer 50, for example, as illustrated in (c) of FIG. 3, a plurality of color splitters CS1 and a plurality of color splitters CS2 are disposed side by side in a checkered pattern.

For example, the color splitter CS1 or the color splitter CS2 is individually formed for each of the pixels 2 (see FIG. 2) in the pixel region 3. Action of these color splitters CS1 and CS2 is explained below.

FIG. 2 is referred back. The organic photoelectric conversion layer 60 is disposed on the surface on the light incident side in the color splitter layer 50. The organic photoelectric conversion layer 60 includes an interlayer insulating film 61 and a photoelectric conversion section 62. The photoelectric conversion section 62 is an example of another photoelectric conversion section. In the organic photoelectric conversion layer 60, the photoelectric conversion section 62 and the interlayer insulating film 61 are stacked in order from the light incident side.

The interlayer insulating film 61 includes, for example, a single-layer film made of one kind among silicon oxide, TEOS, silicon nitride, silicon oxynitride, and the like or a stacked film made of two or more kinds among these.

The photoelectric conversion section 62 includes an upper electrode 62a, a photoelectric conversion layer 62b, a charge storage layer 62c, lower electrodes 62d and 62e, and an insulating layer 62f. In the photoelectric conversion section 62, the upper electrode 62a, the photoelectric conversion layer 62b, the charge storage layer 62c, the insulating layer 62f, and the lower electrodes 62d and 62e are stacked in order from the light incident side.

The upper electrode 62a, the photoelectric conversion layer 62b, the charge storage layer 62c, and the insulating layer 62f are, for example, formed in common in all the pixels 2 in the pixel region 3 and the lower electrodes 62d and 62e are, for example, formed to be separated for each of the pixels 2 in the pixel region 3. That is, for example, as illustrated in (b) of FIG. 3, the photoelectric conversion section 62 is individually formed for each of the pixels 2 (see FIG. 2) in the pixel region 3.

FIG. 2 is referred back. The upper electrode 62a is electrically connected to the wiring film 32 of the wiring layer 30 via a wiring layer, a through electrode (both of which are not illustrated), or the like at the peripheral edge portion of the pixel region 3. As a material of the upper electrode 62a, for example, a transparent conductive material such as indium tin oxide (ITO) is used.

The material of the upper electrode 62a and the lower electrode 62d is not limited to ITO and various transparent conductive materials (for example, tin oxide, zinc oxide, IZO, IGO, IGZO, ATO, and AZO) and the like can be used.

Note that the IZO is an oxide obtained by adding indium to zinc oxide, the IGO is an oxide obtained by adding indium to gallium oxide, and the IGZO is an oxide obtained by adding indium and gallium to zinc oxide. The ATO is an oxide obtained by adding antimony to tin oxide and the AZO is an oxide obtained by adding antimony to zinc oxide.

The photoelectric conversion layer 62b is made of an organic semiconductor material and photoelectrically converts light in a selective wavelength range (for example, a green wavelength region (hereinafter also referred to as "green region")) in the incident light L from the outside. The green wavelength region (the green region) is an example of a third wavelength region.

The photoelectric conversion layer 62b desirably includes one or both of a p-type organic semiconductor and an n-type organic semiconductor. The photoelectric conversion layer 62b is made of, for example, quinacridone, a quinacridone derivative, a subphthalocyanine, a subphthalocyanine derivative, or the like and desirably contains at least one kind among these materials.

Note that the photoelectric conversion layer 62b is not limited to such a material, and may be made of, for example, at least one kind of naphthalene, anthracene, phenanthrene, tetracene, pyrene, perylene, fluoranthene, and the like (all of which include derivatives).

For the photoelectric conversion layer 62b, a polymer or a derivative of phenylenevinylene, fluorene, carbazole, indole, pyrene, pyrrole, picoline, thiophene, acetylene, diacetylene, or the like may be used.

For the photoelectric conversion layer 62b, a metal complex dye, a cyanine dye, a merocyanine dye, a phenylxanthene dye, a triphenylmethane dye, a rhodacyanine dye, a xanthene dye, or the like may be used.

Examples of the metal complex dye include a dithiol metal complex dye, a metal phthalocyanine dye, a metal porphyrin dye, and a ruthenium complex dye. The photoelectric conversion layer 62b may contain other organic materials such as fullerene ($C_{60}$) and BCP (Bathocuproine) besides such an organic semiconductor dye.

When green light is photoelectrically converted by the photoelectric conversion layer 62b, for example, a rhodamine-based dye, a melacyanine-based dye, a quinacridone derivative, a subphthalocyanine-based dye (subphthalocyanine derivative), or the like can be used for the photoelectric conversion layer 62b.

The charge storage layer 62c is provided between the photoelectric conversion layer 62b and the insulating layer 62f, and stores charges generated in the photoelectric conversion layer 62b. The charge storage layer 62c is preferably formed using a material having higher charge mobility and a larger band gap than the photoelectric conversion layer 62b.

For example, the band gap of the constituent material of the charge storage layer 62c is preferably 3.0 eV or more. Examples of such a material include an oxide semiconductor material such as IGZO and an organic semiconductor material.

Examples of the organic semiconductor material include transition metal dichalcogenide, unit silicon (SiC), diamond, graphene, carbon nanotube, a fused polycyclic hydrocarbon compound, and a fused heterocyclic compound.

By providing such a charge storage layer 62c in a layer below the photoelectric conversion layer 62b, it is possible to prevent recombination of charges at the time of charge storage and improve transfer efficiency.

As the material of the lower electrodes 62d and 62e, the same material (for example, ITO) as that of the upper electrode 62a is used. The lower electrode 62d is electrically connected to the charge storage layer 62c and is electrically connected to a metal wire (not illustrated) penetrating the interlayer insulating film 61, the color splitter layer 50, the optical layer 40, and the semiconductor layer 20.

Such a metal wire is formed using a material such as tungsten (W), titanium (Ti), aluminum (Al), or copper (Cu). Note that the metal wire also functions as an inter-pixel light blocking film.

The metal wire is electrically connected to a charge storage section (not illustrated) formed near an interface on the side opposite to the light incident side of the semiconductor region 21. The charge storage section is formed of a semiconductor region of the second conductivity type (for example, N-type).

The lower electrode 62e is electrically connected to the wiring film 32 of the wiring layer 30 via a wiring film 63 formed in the interlayer insulating film 61, a not-illustrated through electrode, or the like.

Charges photoelectrically converted and generated by the photoelectric conversion section 62 are transferred to the charge storage section via the metal wire. Such a charge storage section temporarily stores the charges photoelectrically converted by the photoelectric conversion section 62 until the charges are read by the pixel transistor 33 corresponding to the charge storage section.

Specifically, in the photoelectric conversion section 62, a predetermined voltage is applied from a not-illustrated drive circuit to the lower electrodes 62d and 62e and the upper electrode 62a in a charge storage period. For example, in the charge storage period, a positive voltage is applied to the lower electrodes 62d and 62e and a negative voltage is applied to the upper electrode 62a. Furthermore, in the charge storage period, a positive voltage larger than a positive voltage applied to the lower electrode 62d is applied to the lower electrode 62e.

Accordingly, in the charge storage period, electrons included in the charges photoelectrically converted and generated in the photoelectric conversion layer 62b are attracted by the large positive voltage of the lower electrode 62e and stored in the charge storage layer 62c.

In the pixel 2, a reset operation is performed by causing a not-illustrated reset transistor to operate in a later stage of the charge storage period. Accordingly, the potential of the charge storage section is reset and the potential of the charge storage section becomes a power supply voltage.

In the pixel 2, a charge transfer operation is performed after such a reset operation is completed. In the charge transfer operation, a positive voltage higher than a positive voltage applied to the lower electrode 62e is applied to the lower electrode 62d from the drive circuit. Accordingly, the electrons stored in the charge storage layer 62c are transferred to the charge storage section via the lower electrode 62d and a not-illustrated metal wire.

In the pixel 2, a series of operations such as a charge storage operation, a reset operation, and a charge transfer operation are completed by the operations explained above.

The OCL layer 70 includes a plurality of OCLs 71. For example, as illustrated in (a) of FIG. 3, the OCL 71 formed in a hemispherical shape is a lens that is provided for each of the pixels 2 (see FIG. 2) in the pixel region 3 and condenses the incident light L on the photoelectric conversion sections 62, the photodiodes PD1, and the photodiodes PD2 of the pixels 2. The OCL 71 is made of an acrylic resin or the like.

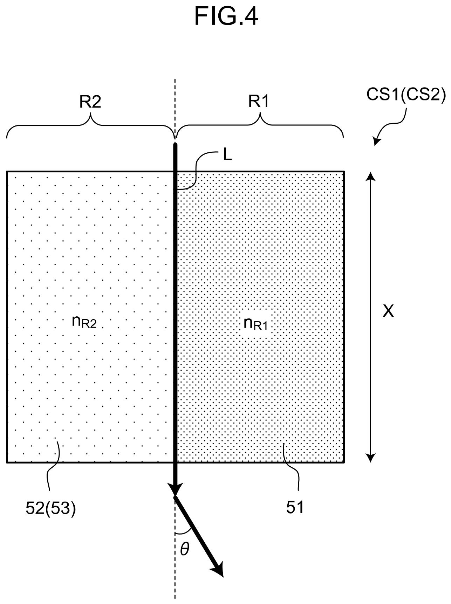

Subsequently, the principle of the color splitters CS1 and CS2 according to the embodiments is described with reference to FIG. 4. FIG. 4 is a diagram for explaining the principle of the color splitters CS1 and CS2 according to the embodiments of the present disclosure.

As illustrated in FIG. 4, a first region R1 where the low refractive index section 51 is located and a second region R2 where the high refractive index sections 52 and 53 are located are arranged in the color splitter CS1 (or the color splitter CS2).

Specifically, in the first region R1, the low refractive index section 51 having a low refractive index (for example, a refractive index $n_{R1}$) is arranged by length X in the light incident direction. In the second region R2, the high refractive index sections 52 and 53 having a high refractive index (for example, a refractive index $n_{R2}$) are arranged by the length X in the light incident direction.

In the color splitter CS1 or the like having such a configuration, when the incident light L is simultaneously made incident on the first region R1 and the second region R2, a difference occurs in a traveling distance of the incident light L between the first region R1 and the second region R2 because of a refractive index difference between the low refractive index section 51 and the high refractive index sections 52 and 53.

Specifically, an optical path length D1 of the first region R1 is calculated by the following Expression (1).

$$D1 = n_{R1} \times X \qquad (1)$$

An optical path length D2 of the second region R2 is calculated by the following Expression (2).

$$D2 = n_{R2} \times X \qquad (2)$$

Based on the Expressions (1) and (2), an optical path length difference $\Delta D$ between the first region R1 and the second region R2 is calculated by the following Expression (3).

$$\Delta D = D2 - D1 = X \times (n_{R2} - n_{R1}) \qquad (3)$$

The incident light L having passed through the color splitters CS1 and CS2 is bent and emitted to the first region R1 to which light travels with delay as illustrated in FIG. 4 according to the optical path length difference $\Delta D$ between the first region R1 and the second region R2.

A bending angle $\theta$ of the incident light L is calculated by the following Expression (4).

$$\theta = \arctan(\Delta D / \lambda) = \arctan(X \times (n_{R2} - n_{R1}) / \lambda) \qquad (4)$$

$\lambda$: wavelength of the incident light L

As indicated by the above Expression (4), the bending angle $\theta$ of the incident light L depends on a wavelength $\lambda$ of the incident light L. For that reason, by selecting the refractive indexes $n_{R1}$ and $n_{R2}$ of the low refractive index section 51 and the high refractive index section 52 as appropriate according to the respective wavelength regions, the color splitters CS1 and CS2 can bend the light in the respective wavelength ranges in different desired directions.

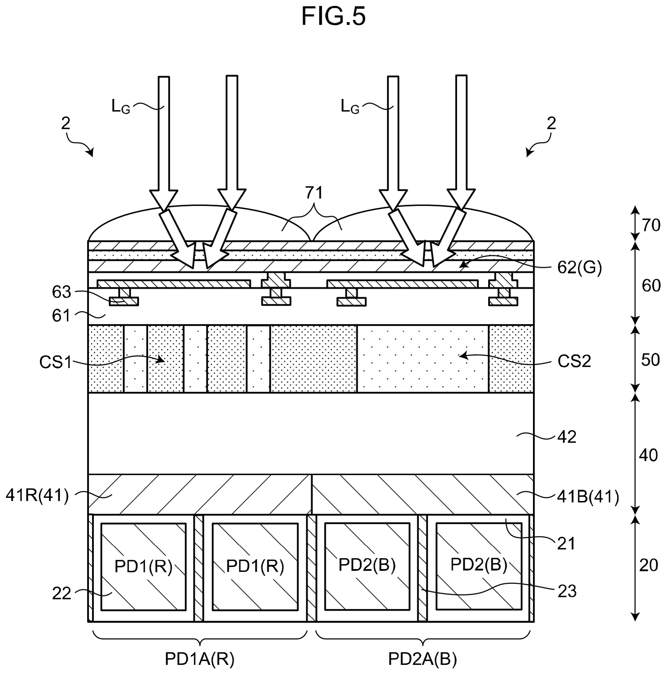

FIG. 5 is a diagram illustrating an incident state of green light $L_G$ in the pixel region 3 according to the first embodiment of the present disclosure. As illustrated in FIG. 5, the green light $L_G$ that is the green wavelength region is absorbed by the photoelectric conversion section 62 located closest to the light incident side among the plurality of photoelectric conversion sections and is photoelectrically converted by such a photoelectric conversion section 62.

In the first embodiment, since the green light $L_G$ focused on the photoelectric conversion section 62 corresponding thereto can be made incident by the OCL 71, the sensitivity of the photoelectric conversion section 62 is improved.

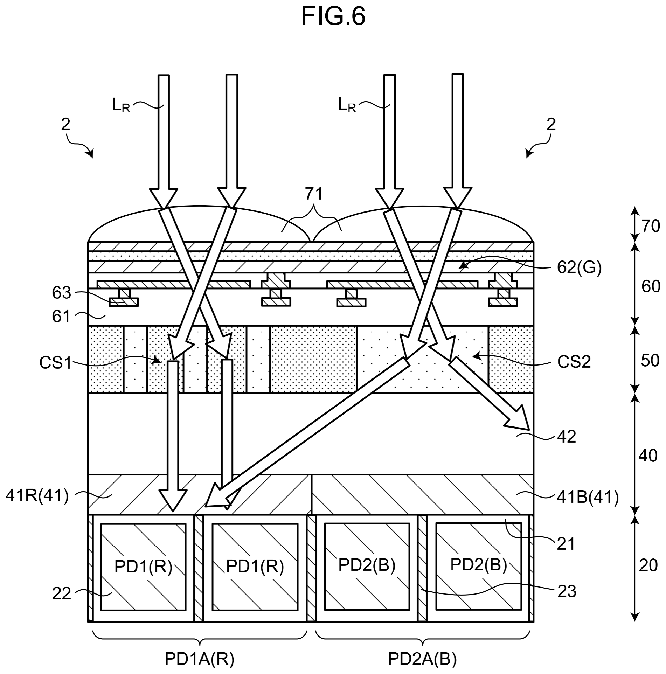

FIG. 6 is a diagram illustrating an incident state of red light $L_R$ in the pixel region 3 according to the first embodiment of the present disclosure. As illustrated in FIG. 6, the red light $L_R$ that is the red wavelength region is partially absorbed by the photoelectric conversion section 62 located closest to the light incident side among the plurality of photoelectric conversion sections and the rest is transmitted. Then, the red light $L_R$ transmitted through the photoelectric conversion section 62 reaches the color splitters CS1 and CS2 in the color splitter layer 50.

Here, in the first embodiment, as illustrated in FIG. 6, the color splitter CS1 makes the red light $L_R$ incident on the photodiode group PD1A near (that is, present immediately below) the color splitter CS1. In other words, in the color splitter CS1 according to the first embodiment, the bending angle $\theta$ is controlled such that the incident red light $L_R$ travels to the photodiode group PD1A present immediately below the color splitter CS1.

In the first embodiment, the color splitter CS2 makes the red light $L_R$ incident on the photodiode group PD1A adjacent thereto (that is, adjacent to the photodiode group PD2A present immediately below the photodiode group PD1A) photodiode group PD1A. In other words, in the color splitter CS2 according to the first embodiment, the bending angle $\theta$ is controlled such that the incident red light $L_R$ travels to the adjacent photodiode group PD1A.

That is, in the first embodiment, in addition to the red light $L_R$ made incident on the OCL 71 present immediately above the photodiode group PD1A, the red light $L_R$ made incident on the adjacent OCL 71 can also be made incident on the photodiode group PD1A.

In other words, in the first embodiment, the focused red light $L_R$ is made incident on the photodiode group PD1A from a color splitter region configured by the color splitter CS1 immediately above the photodiode group PD1A and the plurality of color splitters CS2 adjacent to such a color splitter CS1 immediately above the photodiode group PD1A.

Therefore, in the first embodiment, it is possible to improve the sensitivity of the photodiode group PD1A that photoelectrically converts the red light $L_R$.

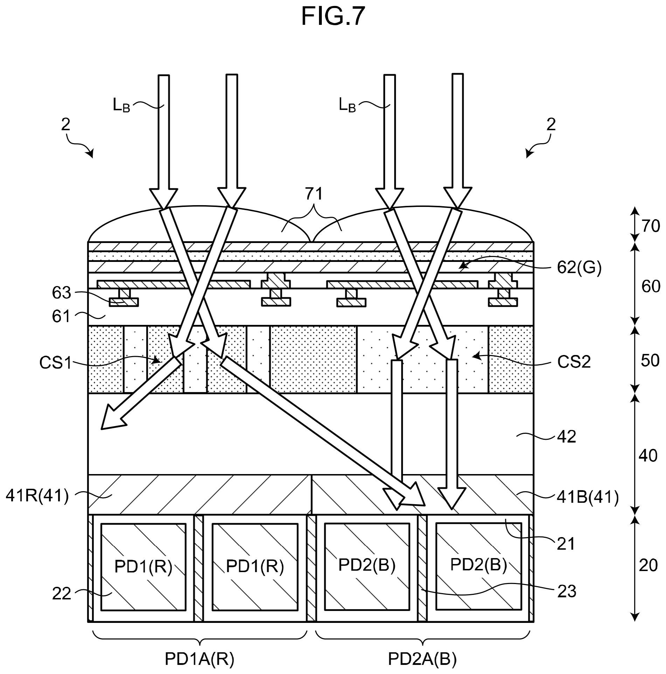

FIG. 7 is a diagram illustrating an incident state of the blue light $L_B$ in the pixel region 3 according to the first embodiment of the present disclosure. As illustrated in FIG. 7, a part of the blue light $L_B$ that is the blue wavelength region is absorbed by the photoelectric conversion section 62 located closest to the light incident side among the plurality of photoelectric conversion sections and the rest is transmitted. Then, the blue light $L_B$ transmitted through the photoelectric conversion section 62 reaches the color splitters CS1 and CS2 in the color splitter layer 50.

Here, in the first embodiment, as illustrated in FIG. 7, the color splitter CS2 makes the blue light $L_B$ incident on the photodiode group PD2A near (that is, present immediately below) the color splitter CS2. In other words, in the color splitter CS2 according to the first embodiment, the bending angle $\theta$ is controlled such that the incident blue light $L_B$ travels to the photodiode group PD2A present immediately below the color splitter CS2.

In the first embodiment, the color splitter CS1 makes the blue light $L_B$ incident on the photodiode group PD2A adjacent to the color splitter CS1 (that is, adjacent to the photodiode group PD1A present immediately below the color splitter CS1). In other words, in the color splitter CS1 according to the first embodiment, the bending angle $\theta$ is controlled such that the incident blue light $L_B$ travels to the adjacent photodiode group PD2A.

That is, in the first embodiment, in addition to the blue light $L_B$ made incident on the OCL 71 present immediately above the photodiode group PD2A, the blue light $L_B$ made incident on the OCL 71 adjacent to the photodiode group PD2A can also be incident on the photodiode group PD2A.

In other words, in the first embodiment, the focused blue light $L_B$ is made incident on the photodiode group PD2A from a color splitter region configured by the color splitter CS2 immediately above the photodiode group PD2A and the plurality of color splitters CS1 adjacent to the immediately upper color splitter CS2 immediately above the photodiode group PD2A.

Therefore, in the first embodiment, it is possible to improve the sensitivity of the photodiode group PD2A that photoelectrically converts the blue light $L_B$.

As explained above, in the first embodiment, by disposing the color splitters CS1 and CS2 further on the light incident side than the photodiode groups PD1A and PD2A, it is possible to improve the sensitivity of the photodiode groups PD1A and PD2A.

Furthermore, in the first embodiment, the two photodiodes PD1 belonging to the same photodiode group PD1A are configured as photoelectric conversion sections capable of acquiring a phase difference of an image plane.

In this case, the two photodiodes PD1 belonging to the same photodiode group PD1A share a color splitter region in the same range, which is configured by the color splitter CS1 immediately above the two photodiodes PD1 and the plurality of color splitters CS2 adjacent to such a color splitter CS1.

In such a structure, the red light $L_R$ made incident on the two photodiodes PD1 belonging to the same photodiode group PD1A is photoelectrically converted by the respective photodiodes PD1 to generate electrons that become read charges.

The generated electrons are sequentially transferred to a floating diffusion region of a pixel circuit via a transfer transistor and are read as pixel signals of the respective photodiodes PD1. The column signal processing circuit 5 (see FIG. 1) to which the read pixel signals are input detects a phase difference by comparing signal amounts of the respective photodiodes PD1 and calculates a distance to a target object based on the detected phase difference.

In the first embodiment, as illustrated in FIG. 6, since the red light $L_R$ focused by the color splitter layer 50 is made incident on the photodiode group PD1A, it is possible to improve the detection sensitivity of a phase difference in the red light $L_R$.

Similarly, in the first embodiment, the two photodiodes PD2 belonging to the same photodiode group PD2A are configured as photoelectric conversion sections capable of acquiring a phase difference of an image plane.

In this case, the two photodiodes PD2 belonging to the same photodiode group PD2A share a color splitter region in the same range, which is configured by the color splitter CS2 immediately above the two photodiodes PD2 and the plurality of color splitters CS1 adjacent to such a color splitter CS2.

In such a structure, the blue light $L_B$ made incident on the two photodiodes PD2 belonging to the same photodiode group PD2A is photoelectrically converted by the respective photodiodes PD2 to generate electrons that become read charges.

The generated electrons are sequentially transferred to a floating diffusion region of a pixel circuit via a transfer transistor and are read as pixel signals of the respective photodiode PD2. The column signal processing circuit 5 (see FIG. 1) to which the read pixel signals are input detects a phase difference by comparing signal amounts of the respective photodiodes PD2 and calculates a distance to a target object based on the detected phase difference.

In the first embodiment, as illustrated in FIG. 7, since the blue light $L_B$ focused by the color splitter layer 50 is made incident on the photodiode group PD2A, it is possible to improve the detection sensitivity of a phase difference in the blue light $L_B$.

In the present disclosure, it is desirable that the color splitters CS1 and CS2 have a meta-surface structure. Such a meta-surface structure is a structure in which the high refractive index sections 52 and 53 formed in one color splitter CS1 and one color splitter CS2 are arrayed at a cycle equal to or smaller than the wavelength $\lambda$ of the incident light L.

Accordingly, since effective refractive indexes of the color splitters CS1 and CS2 can be changed, it is possible to further bend the light in the wavelength region of each of the red region and the blue region in a desired direction.

Therefore, according to the first embodiment, it is possible to improve the sensitivity of the photodiode groups PD1A and PD2A that respectively photoelectrically convert the red light $L_R$ and the blue light $L_B$. Furthermore, in the first embodiment, it is possible to improve the detection sensitivity of phase differences in the red light $L_R$ and the blue light $L_B$.

In the first embodiment, the color filter 41R may be disposed between the color splitter CS1 and the photodiode group PD1A and the color filter 41B may be disposed between the color splitter CS2 and the photodiode group PD2A.

As explained above, by disposing the color filters 41R and 43B having better spectral characteristics than the color splitters CS1 and CS2, it is possible to suppress occurrence of color mixing in the photodiode groups PD1A and PD2A.

In the first embodiment, it is desirable that, among the plurality of photoelectric conversion sections, the photoelectric conversion section 62 on the light incident side photoelectrically converts light in the green region and the photodiode groups PD1A and PD2A on the side opposite to the light incident side photoelectrically converts light in the red region and the blue region.

Accordingly, the incident light L reaching the photodiode groups PD1A and PD2A can be dispersed in advance by the photoelectric conversion section 62 into light having a longer wavelength than the green region (that is, the red light $L_R$) and light having a shorter wavelength than the green region (that is, the blue light $L_B$).

Therefore, according to the first embodiment, it is possible to suppress occurrence of color mixing in the photodiode groups PD1A and PD2A. Note that, in the present disclosure, the color filter 41 may not be necessarily provided in the optical layer 40.

In the first embodiment, it is desirable that the buffer layer 42 is provided in the optical layer 40. Accordingly, even if the bending angle $\theta$ of the color splitters CS1 and CS2 is further reduced, it is possible to efficiently make the red light $L_R$ or the blue light $L_B$ incident on the desired photodiode groups PD1A and PD2A.

That is, in the first embodiment, since the buffer layer 42 is provided in the optical layer 40, it is possible to make the more focused red light $L_R$ or blue light $L_B$ incident on the desired photodiode group PD1A or photodiode group PD2A. Therefore, according to the first embodiment, it is possible to further improve the detection sensitivity of phase differences in the red light $L_R$ or the blue light $L_B$.

In the first embodiment, the organic photoelectric conversion layer 60 may be disposed further on the light incident side than the color splitter layer 50. Accordingly, the incident light L reaching the color splitters CS1 and CS2 can be dispersed in advance by the photoelectric conversion section 62 into light having a longer wavelength than the green region (that is, the red light $L_R$) and light having a shorter wavelength than the green region (that is, blue light $L_B$).

Therefore, according to the first embodiment, it is possible to suppress occurrence of color mixing in the photodiode groups PD1A and PD2A.

Note that, in the first embodiment explained above, an example is explained in which the light in the green region is photoelectrically converted by the photoelectric conversion section 62 on the light incident side and the light in the red region and the light in the blue region are photoelectrically converted by the semiconductor layer 20 on the back side. However, the present disclosure is not limited to such an example.

For example, in the present disclosure, the light in the red region may be photoelectrically converted by the photoelectric conversion section 62 on the light incident side and the light in the green region and the light in the blue region may be photoelectrically converted by the semiconductor layer 20 on the back side. In the present disclosure, the light in the blue region may be photoelectrically converted by the photoelectric conversion section 62 on the light incident side and the light in the red region and the light in the green region may be photoelectrically converted by the semiconductor layer 20 on the back side.

[Various modifications of the first embodiment]

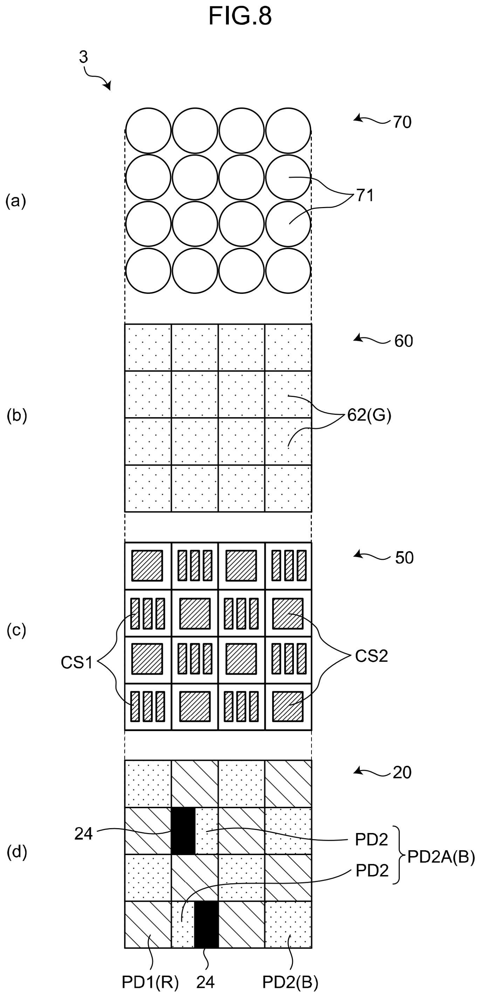

Subsequently, various modifications of the first embodiment are explained with reference to FIG. 8 to FIG. 15. FIG. 8 is a diagram for explaining a stacked structure and a planar structure of the pixel region 3 according to a modification 1 of the first embodiment of the present disclosure and is a diagram corresponding to FIG. 3 in the first embodiment.

As illustrated in FIG. 8, in the present modification 1, the configuration of the semiconductor layer 20 is different from that in the first embodiment explained above (see FIG. 3). Specifically, in the present modification 1, the photodiode groups PD1A and PD2A are not provided in most of the pixels 2 (see FIG. 2) and one photodiode PD1 or one photodiode PD2 is provided in most of the pixels 2.

On the other hand, the photodiode PD2, a light receiving area of which is halved by a light blocking film 24 located on one side (for example, the left side), is provided in a part of the pixels 2. Similarly, the photodiode PD2, a light receiving area of which is halved by the light blocking film 24 located on the other side (for example, the right side), is provided in another part of the pixels 2 close to the part of the pixels 2.

One photodiode group PD2A is configured by these two photodiodes PD2 having the halved areas. In the present modification 1, the two photodiodes PD2 belonging to the same photodiode group PD2A are configured as photoelectric conversion sections capable of acquiring a phase difference of an image plane.

Accordingly, it is possible to improve the sensitivity of the photodiode group PD2A that photoelectrically converts the blue light $L_B$ (see FIG. 7). Further, in the present modification 1, it is possible to improve the detection sensitivity of a phase difference in the blue light $L_B$.

Note that, in the example illustrated in FIG. 8, an example is explained in which one photodiode group PD2A is configured by the two photodiodes PD2, light receiving areas of which are halved. However, the present disclosure is not limited to such an example.

For example, one photodiode group PD1A (see FIG. 3) may be configured by two photodiodes PD1, light receiving areas of which are halved, and such two photodiodes PD1 may be configured as a photoelectric conversion section capable of acquiring a phase difference of an image plane. Accordingly, it is possible to improve the detection sensitivity of a phase difference in the red light $L_R$ (see FIG. 6).

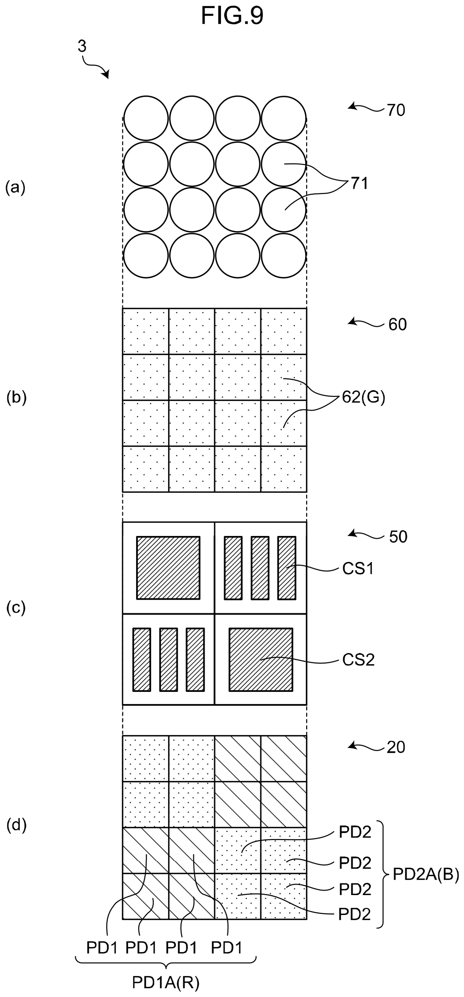

FIG. 9 is a diagram for explaining a stacked structure and a planar structure of the pixel region 3 according to a modification 2 of the first embodiment of the present disclosure. As illustrated in FIG. 9, in the present modification 2, configurations of the color splitter layer 50 and the semiconductor layer 20 are different from those in the first embodiment explained above (see FIG. 3).

Specifically, in the present modification 2, the color splitters CS1 and CS2 having an area equivalent to two × two OCLs 71 are provided in the color splitter layer 50. On the back side of the color splitter CS1, two × two, that is, four photodiodes PD1 in total are located.

One photodiode group PD1A is configured by the four photodiodes PD1. Furthermore, in the present modification 2, the four photodiodes PD1 belonging to the same photodiode group PD1A are configured as photoelectric conversion sections capable of acquiring a phase difference of an image plane.

In this case, the four photodiodes PD1 belonging to the same photodiode group PD1A share a color splitter region in the same range configured by the color splitter CS1 immediately above the four photodiodes PD1 and the plurality of color splitters CS2 adjacent to such a color splitter CS1.

In the present modification 2, since the red light $L_R$ (see FIG. 6) focused by the color splitter layer 50 is made incident on the photodiode group PD1A, it is possible to improve the detection sensitivity of a phase difference in the red light $L_R$.

In the present modification 2, two × two, that is, four photodiodes PD2, in total are located on the back side of the color splitter CS2.

One photodiode group PD2A is configured by the four photodiodes PD2. Furthermore, in the present modification 2, the four photodiodes PD2 belonging to the same photodiode group PD2A are configured as photoelectric conversion sections capable of acquiring a phase difference of an image plane.

In this case, the four photodiodes PD2 belonging to the same photodiode group PD2A share a color splitter region in the same range configured by the color splitter CS2 immediately above the four photodiodes PD2 and the plurality of color splitters CS1 adjacent to such a color splitter CS2.

In the present modification 2, since the blue light $L_B$ (see FIG. 7) focused by the color splitter layer 50 is made incident on the photodiode group PD2A, it is possible to improve the detection sensitivity of a phase difference in the blue light $L_B$.

In the present modification 2, since the photodiode groups PD1A and PD2A respectively include the two × two photodiodes PD1 and the two × two photodiodes PD2, it is possible to measure the distance to a target object regardless of a texture direction and a color of the target object.

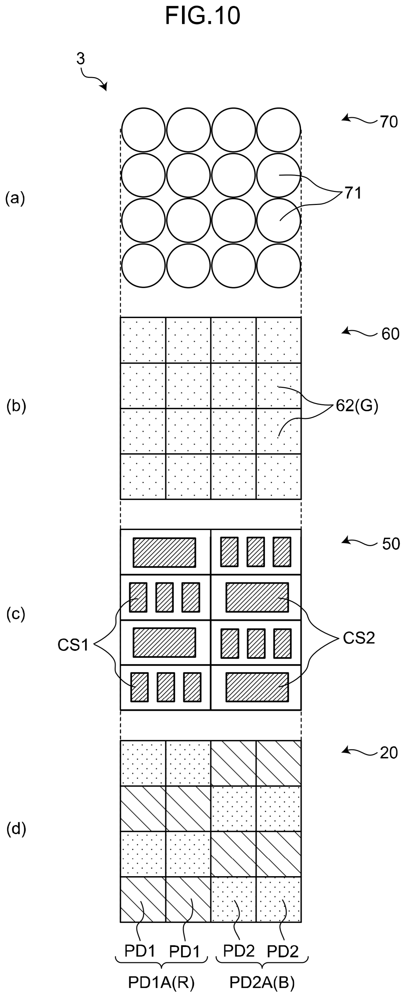

FIG. 10 is a diagram for explaining a stacked structure and a planar structure of the pixel region 3 according to a modification 3 of the first embodiment of the present disclosure. As illustrated in FIG. 10, in the present modification 3, configurations of the color splitter layer 50 and the semiconductor layer 20 are different from those in the first embodiment explained above (see FIG. 3).

Specifically, in the present modification 3, the color splitters CS1 and CS2 having an area equivalent to two × one OCLs 71 are provided in the color splitter layer 50. Two × one, that is, two photodiodes PD1 in total are located on the back side of the color splitter CS1.

One photodiode group PD1A is configured by the two photodiodes PD1. Furthermore, in the present modification 3, the two photodiodes PD1 belonging to the same photodiode group PD1A are configured as photoelectric conversion sections capable of acquiring a phase difference of an image plane.

In this case, the two photodiodes PD1 belonging to the same photodiode group PD1A share a color splitter region in the same range, which is configured by the color splitter CS1 immediately above the two photodiodes PD1 and the plurality of color splitters CS2 adjacent to such a color splitter CS1.

In the present modification 3, since the red light $L_R$ (see FIG. 6) focused by the color splitter layer 50 is made incident on the photodiode group PD1A, it is possible to improve the detection sensitivity of the phase difference in the red light $L_R$.

In the present modification 3, two × one, that is, two photodiodes PD2 in total are located on the back side of the color splitter CS2.

One photodiode group PD2A is configured by the two photodiodes PD2. Furthermore, in the present modification 3, the two photodiodes PD2 belonging to the same photodiode group PD2A are configured as photoelectric conversion sections capable of acquiring a phase difference of an image plane.

In this case, the two photodiodes PD2 belonging to the same photodiode group PD2A share a color splitter region in the same range, which is configured by the color splitter CS2 immediately above the two photodiodes PD2 and the plurality of color splitters CS1 adjacent to such a color splitter CS2.

In the present modification 3, since the blue light $L_B$ (see FIG. 7) focused by the color splitter layer 50 is made incident on the photodiode group PD2A, it is possible to improve the detection sensitivity of the phase difference in the blue light $L_B$.

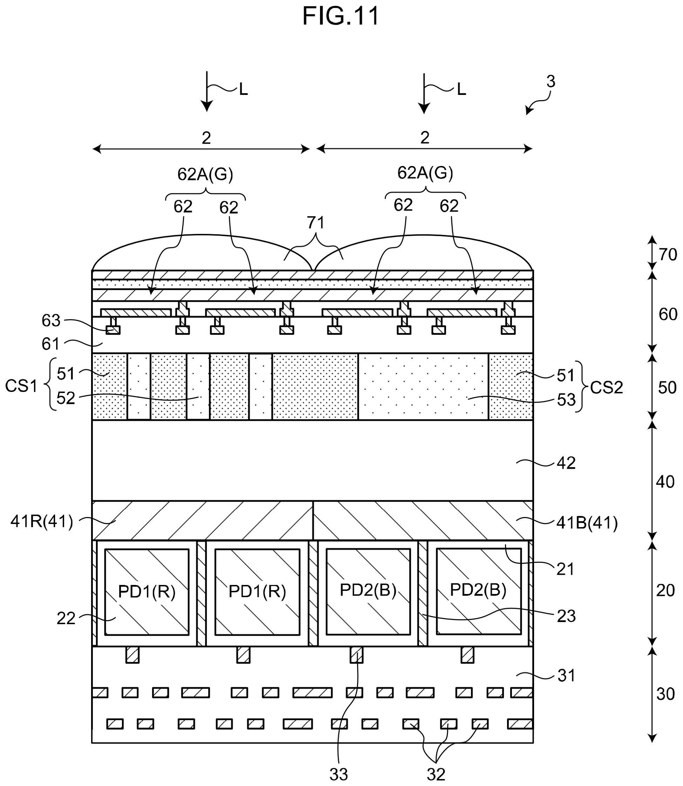

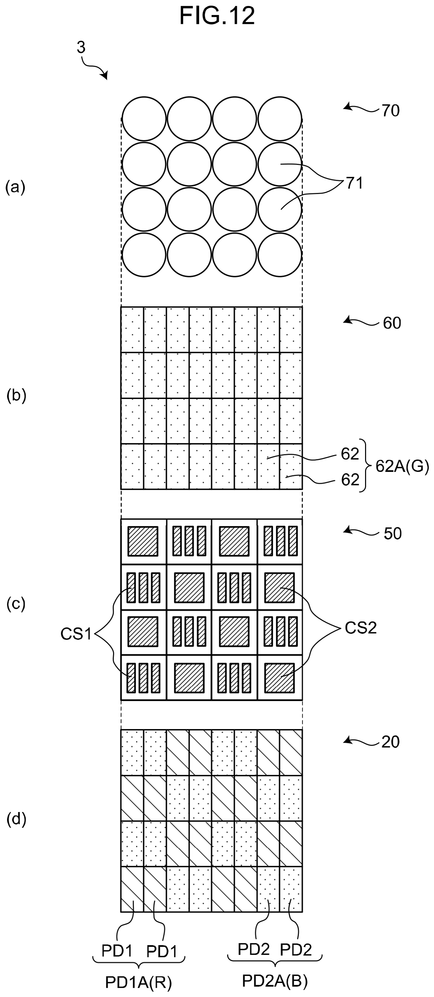

FIG. 11 is a cross-sectional view schematically illustrating a structure of the pixel region 3 according to a modification 4 of the first embodiment of the present disclosure. FIG. 12 is a diagram for explaining a stacked structure and a planar structure of the pixel region 3 according to the modification 4 of the first embodiment of the present disclosure.

As illustrated in FIG. 11 and FIG. 12, in the present modification 4, a configuration of the organic photoelectric conversion layer 60 is different from that in the first embodiment explained above (see FIG. 2 and FIG. 3). Specifically, in the present modification 4, two photoelectric conversion sections 62 are located on the back side of one OCL 71 and one photoelectric conversion section group 62A is configured by such two photoelectric conversion sections 62. The photoelectric conversion section group 62A is an example of another photoelectric conversion section group.

In the present modification 4, the two photoelectric conversion sections 62 belonging to the same photoelectric conversion section group 62A are configured as photoelectric conversion sections capable of acquiring a phase difference of an image plane. In this case, the two photoelectric conversion sections 62 belonging to the same photoelectric conversion section group 62A share the OCL 71 immediately above the two photoelectric conversion sections 62.

In the present modification 4, since the green light $L_G$ (see FIG. 5) focused by the OCL 71 is made incident on the photoelectric conversion section group 62A, it is possible to improve the detection sensitivity of a phase difference in the green light $L_G$.

In the present modification 4, since the OCL 71 and the color splitter layer 50 can respectively focus light of all RGB three colors, it is possible to improve the detection sensitivity of a phase difference in the light of all the RGB three colors.

Note that, in the example illustrated in FIG. 12, an example in which the color splitter layer 50 and the semiconductor layer 20 have the same configurations as those in the first embodiment explained above (see FIG. 3) is explained. However, the present disclosure is not limited to such an example. For example, in the example illustrated in FIG. 12, the semiconductor layer 20 may have the same configuration as that in the modification 1 explained above (see FIG. 8).

In the example illustrated in FIG. 12, the color splitter layer 50 and the semiconductor layer 20 may have the same configurations as those in the modification 2 explained above (see FIG. 9) and the color splitter layer 50 and the semiconductor layer 20 may have the same configurations as those in the modification 3 explained above (see FIG. 10).

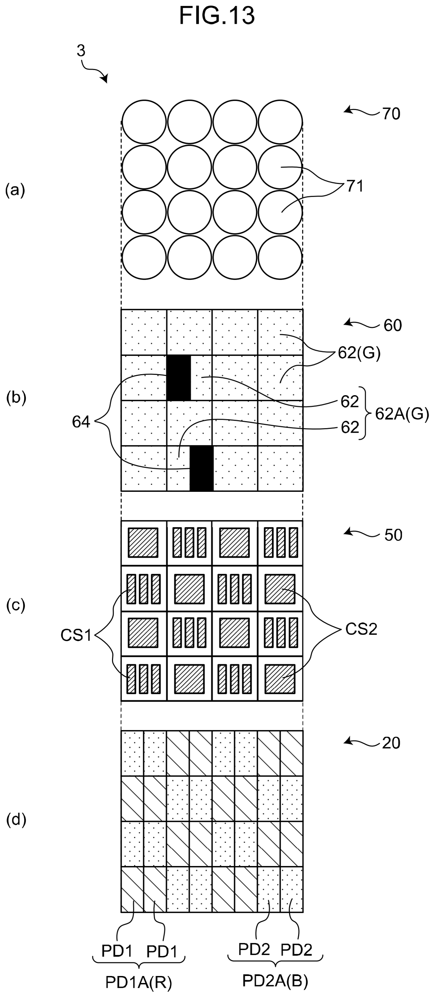

FIG. 13 is a diagram for explaining a stacked structure and a planar structure of the pixel region 3 according to a modification 5 of the first embodiment of the present disclosure. As illustrated in FIG. 13, in the present modification 5, a configuration of the organic photoelectric conversion layer 60 is different from that of in the modification 4 (see FIG. 12) of the first embodiment explained above.

Specifically, in the present modification 5, the photoelectric conversion section group 62A is not provided in most of the pixels 2 and one photoelectric conversion section 62 is provided in most of the pixels 2.

On the other hand, the photoelectric conversion section 62, a light receiving area of which is halved by a light blocking film 64 located on one side (for example, the left side), is provided in a part of the pixels 2. Similarly, the photoelectric conversion section 62, a light receiving area of which is halved by the light blocking film 64 located on the other side (for example, the right side), is provided in another part of the pixels 2 close to the part of the pixels 2.

One photoelectric conversion section group 62A is configured by these two photoelectric conversion sections 62 having the halved area. Furthermore, in the present modification 5, the two photoelectric conversion sections 62 belonging to the same photoelectric conversion section group 62A are configured as photoelectric conversion sections capable of acquiring a phase difference of an image plane.

Here, in the present modification 5, since the green light $L_G$ (see FIG. 5) focused by the OCL 71 is made incident on the photoelectric conversion section group 62A, it is possible to improve the detection sensitivity of a phase difference in the green light $L_G$.

In the present modification 5, since the OCL 71 and the color splitter layer 50 can respectively focus light of all the RGB three colors, it is possible to improve the detection sensitivity of a phase difference in the light of all the RGB three colors.

Note that, in the example illustrated in FIG. 13, an example is explained in which the color splitter layer 50 and the semiconductor layer 20 have the same configurations as those in the first embodiment explained above (see FIG. 3). However, the present disclosure is not limited to such an example. For example, in the example illustrated in FIG. 13, the semiconductor layer 20 may have the same configuration as that in the present modification 1 explained above (see FIG. 8).

In the example illustrated in FIG. 13, the color splitter layer 50 and the semiconductor layer 20 may have the same configurations as those in the modification 2 (see FIG. 9) and the color splitter layer 50 and the semiconductor layer 20 may have the same configurations as those in the modification 3 explained above (see FIG. 10).

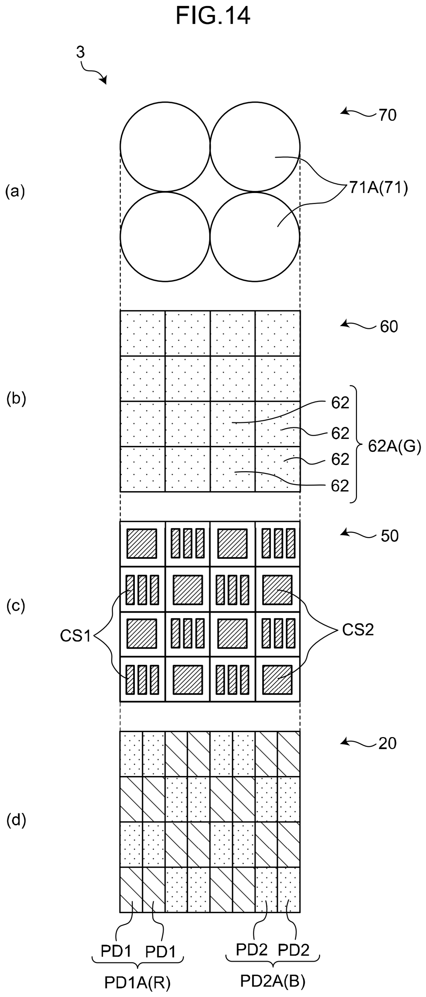

FIG. 14 is a diagram for explaining a stacked structure and a planar structure of the pixel region 3 according to a modification 6 of the first embodiment of the present disclosure. As illustrated in FIG. 14, in the present modification 6, configurations of the OCL layer 70 and the organic photoelectric conversion layer 60 are different from those in the modification 4 (see FIG. 12) of the first embodiment explained above.

Specifically, in the present modification 6, a plurality of OCLs 71A having an area of two × two pixels 2 (see FIG. 11) are provided side by side in the OCL layer 70 in a matrix. Two × two, that is, four photoelectric conversion sections 62 in total are located on the back side of one OCL 71A.

One photoelectric conversion section group 62A is configured by the four photoelectric conversion sections 62. Furthermore, in the present modification 6, the four photoelectric conversion sections 62 belonging to the same photoelectric conversion section group 62A are configured as photoelectric conversion sections capable of acquiring a phase difference of an image plane. In this case, the four photoelectric conversion sections 62 belonging to the same photoelectric conversion section group 62A share the OCL 71A immediately above the four photoelectric conversion sections 62.

In the present modification 6, since the green light $L_G$ (see FIG. 5) focused by the OCL 71A is made incident on the photoelectric conversion section group 62A, it is possible to improve the detection sensitivity of a phase difference in the green light $L_G$.

In the present modification 6, since the OCL 71A and the color splitter layer 50 can respectively focus light of all the RGB three colors, it is possible to improve the detection sensitivity of a phase difference in the light of all the RGB three colors.

In the present modification 6, since the photoelectric conversion section group 62A includes two × two photoelectric conversion sections 62, it is possible to measure the distance to a target object regardless of a texture direction.

Note that, in the example illustrated in FIG. 14, an example is explained in which the color splitter layer 50 and the semiconductor layer 20 have the same configurations as those in the first embodiment explained above (see FIG. 3). However, the present disclosure is not limited to such an example. For example, in the example illustrated in FIG. 14, the semiconductor layer 20 may have the same configuration as that in the modification 1 explained above (see FIG. 8).

In the example illustrated in FIG. 14, the color splitter layer 50 and the semiconductor layer 20 may have the same configurations as those in the modification 2 explained above (see FIG. 9) and the color splitter layer 50 and the semiconductor layer 20 may have the same configurations as those in the modification 3 explained above (see FIG. 10).

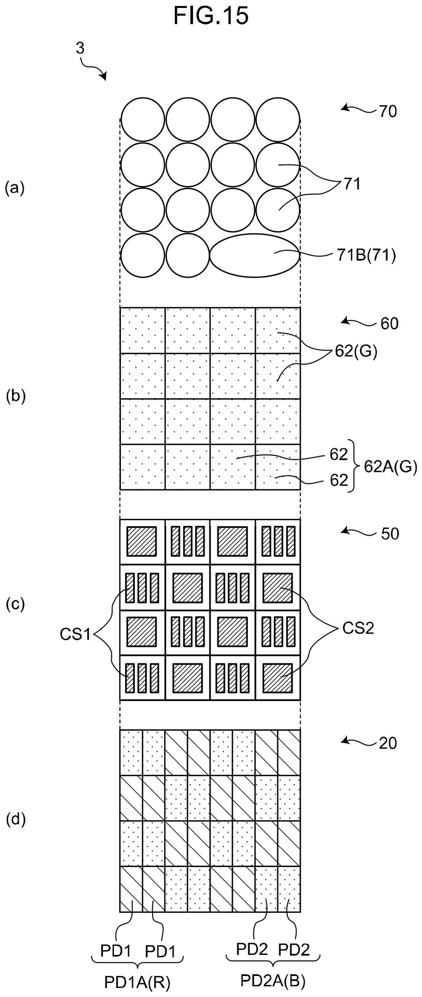

FIG. 15 is a diagram for explaining a stacked structure and a planar structure of the pixel region 3 according to a modification 7 of the first embodiment of the present disclosure. As illustrated in FIG. 15, in the present modification 7, a configuration of the OCL layer 70 is different from that in the first embodiment explained above (see FIG. 3).

Specifically, in the modification 7, a semi-elliptical spherical OCL 71B having an area of two × one pixels 2 (see FIG. 11) is provided in a part of the OCL layer 70. Two × one, that is, two photoelectric conversion sections 62 in total are located on the back side of the OCL 71B.

One photoelectric conversion section group 62A is configured by the two photoelectric conversion sections 62. Furthermore, in the present modification 7, the two photoelectric conversion sections 62 belonging to the same photoelectric conversion section group 62A are configured as photoelectric conversion sections capable of acquiring a phase difference of an image plane. In this case, the two photoelectric conversion sections 62 belonging to the same photoelectric conversion section group 62A share the OCL 71B immediately above the two photoelectric conversion sections 62.

In the present modification 7, since the green light $L_G$ (see FIG. 5) focused by the OCL 71B is made incident on the photoelectric conversion section group 62A, it is possible to improve the detection sensitivity of a phase difference in the green light $L_G$.

In the present modification 7, since the OCL 71B and the color splitter layer 50 can respectively focus light of all the RGB three colors, it is possible to improve the detection sensitivity of a phase difference in the light of all the RGB three colors.

Note that, in the example illustrated in FIG. 15, an example is explained in which the color splitter layer 50 and the semiconductor layer 20 have the same configurations as those in the first embodiment explained above (see FIG. 3). However, the present disclosure is not limited to such an example. For example, in the example illustrated in FIG. 15, the semiconductor layer 20 may have the same configuration as that in the first embodiment explained above (see FIG. 8).

In the example illustrated in FIG. 15, the color splitter layer 50 and the semiconductor layer 20 may have the same configurations as those in the modification 2 explained above (see FIG. 9) and the color splitter layer 50 and the semiconductor layer 20 may have the same configurations as those in the modification 3 explained above (see FIG. 10).

[Second Embodiment]

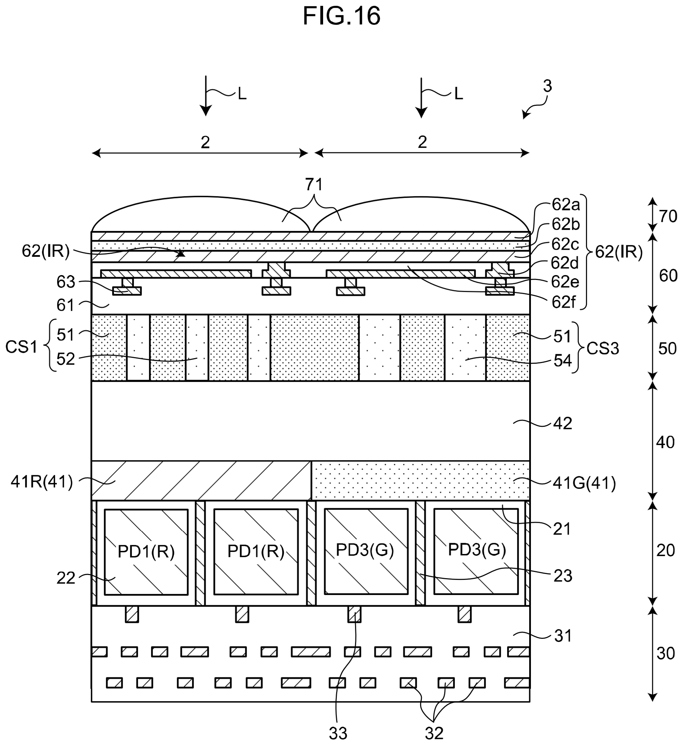

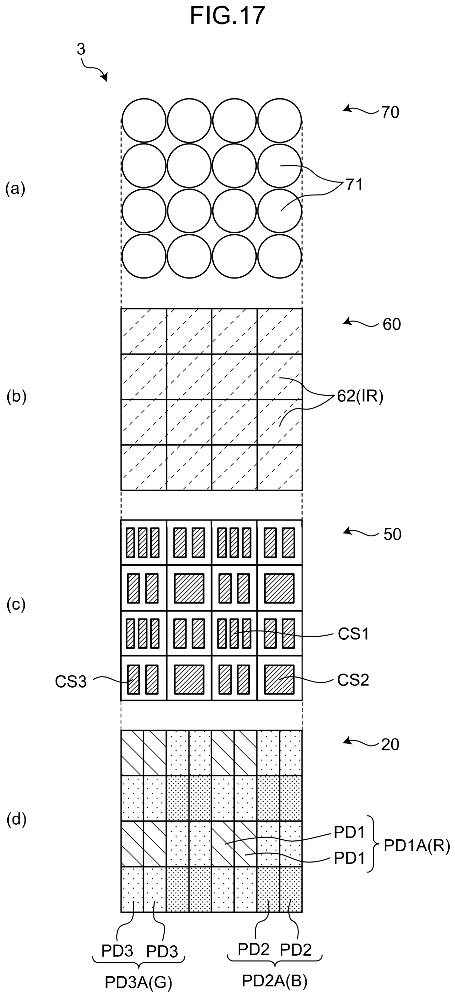

Subsequently, a detailed configuration of the pixel region 3 according to a second embodiment is explained with reference to FIG. 16 and FIG. 17. FIG. 16 is a cross-sectional view schematically illustrating a structure of the pixel region 3 according to the second embodiment of the present disclosure. FIG. 17 is a diagram for explaining a stacked structure and a planar structure of the pixel region 3 according to the second embodiment of the present disclosure.

The pixel region 3 in the second embodiment includes the semiconductor layer 20, the wiring layer 30, the optical layer 40, the color splitter layer 50, the organic photoelectric conversion layer 60, and the OCL layer 70. In the pixel region 3, the OCL layer 70, the organic photoelectric conversion layer 60, the color splitter layer 50, the optical layer 40, the semiconductor layer 20, and the wiring layer 30 are stacked in order from the light incident side.

The semiconductor layer 20 includes a semiconductor region 21 of a first conductivity type (for example, P-type), a semiconductor region 22 of a second conductivity type (for example, N-type), and a separation section 23. In the semiconductor region 21 of the first conductivity type, the semiconductor regions 22 of the second conductivity type are formed side by side in the plane direction (the array direction of the pixels 2) in units of pixels, whereby photodiodes PD1, PD2, and PD3 by PN junction are formed side by side in the plane direction. The photodiode PD3 is an example of a third photoelectric conversion section.

For example, the photodiode PD1 is a photoelectric conversion section that receives and photoelectrically converts light in the red region. The photodiode PD2 is a photoelectric conversion section that receives and photoelectrically converts light in the blue region. The photodiode PD3 is a photoelectric conversion section that receives and photoelectrically converts light in the green region. That is, in the second embodiment, the semiconductor layer 20 photoelectrically converts light of the RGB three colors.

In the second embodiment, as illustrated in (d) of FIG. 17, the photodiode group PD1A is configured by two photodiodes PD1 adjacent to each other. The photodiode group PD2A is configured by two photodiodes PD2 adjacent to each other and a photodiode group PD3A is configured by two photodiodes PD3 adjacent to each other. The photodiode group PD3A is an example of a photoelectric conversion section group.

In the semiconductor layer 20, for example, a plurality of photodiode groups PD1A, a plurality of photodiode groups PD2A, and a plurality of photodiode groups PD3A are disposed in a so-called Bayer array. The photodiode group PD1A, the photodiode group PD2A, or the photodiode group PD3A is individually formed, for example, for each of the pixels 2 (see FIG. 16) in the pixel region 3.

FIG. 16 is referred back. The separation section 23 of the semiconductor layer 20 electrically and optically separates the photodiodes PD1 adjacent to each other, the photodiodes PD1 and PD2 adjacent to each other, and the photodiodes PD2 adjacent to each other.

The separation section 23 electrically and optically separates the photodiodes PD3 adjacent to each other, the photodiodes PD1 and PD3 adjacent to each other, and the photodiodes PD2 and PD3 adjacent to each other. Note that, in the present disclosure, the photodiodes PD3 belonging to the same photodiode group PD3A may be electrically connected to each other by an overflow path.

The optical layer 40 is disposed on the surface on the light incident side in the semiconductor layer 20. The optical layer 40 includes a color filter 41 and a buffer layer 42. In the optical layer 40, the color filter 41 and the buffer layer 42 are stacked in order from the light incident side.

The color filter 41 is an optical filter that transmits light in a predetermined wavelength region in the incident light L. The color filter 41 includes, for example, the color filter 41R that transmits light in the red region, the color filter 41B (see FIG. 2) that transmits light in the blue region, and a color filter 41G that transmits light in the green region.

The color filter 41R is disposed on the light incident side of the photodiode group PD1A (see FIG. 17). The color filter 41B is disposed on the light incident side of the photodiode group PD2A (see FIG. 17).

The color filter 41G is disposed on the light incident side of the photodiode group PD3A (see FIG. 17). The color filter 41R, the color filter 41B, or the color filter 41G are, for example, individually formed for each of the pixels 2 in the pixel region 3.

The color splitter layer 50 is disposed on the surface on the light incident side in the optical layer 40. The color splitter layer 50 includes a low refractive index section 51, a high refractive index section 52, a high refractive index section 53 (see FIG. 2), and a high refractive index section 54.

The high refractive index sections 52, 53, and 54 are made of a material having a refractive index higher than that of the low refractive index section 51. The high refractive index section 52 has a predetermined planar shape on the inside of the color splitter layer 50 and is disposed on the light incident side of the photodiode group PD1A. On the light incident side of the photodiode group PD1A, a color splitter CS1 is configured by the low refractive index section 51 and the high refractive index section 52.

The high refractive index section 53 has a predetermined planar shape on the inside of the color splitter layer 50 and is disposed on the light incident side of the photodiode group PD2A. On the light incident side of the photodiode group PD2A, a color splitter CS2 (see FIG. 17) is configured by the low refractive index section 51 and the high refractive index section 53.

The high refractive index section 54 has a predetermined planar shape on the inside of the color splitter layer 50 and is disposed on the light incident side of the photodiode group PD3A. On the light incident side of the photodiode group PD3A, a color splitter CS3 is configured by the low refractive index section 51 and the high refractive index section 54.

The color splitter CS1, the color splitter CS2, or the color splitter CS3 is, for example, individually formed for each of the pixels 2 of the pixel region 3.

The organic photoelectric conversion layer 60 is disposed on the surface on the light incident side in the color splitter layer 50. The organic photoelectric conversion layer 60 includes an interlayer insulating film 61 and a photoelectric conversion section 62. In the organic photoelectric conversion layer 60, the photoelectric conversion section 62 and the interlayer insulating film 61 are stacked in order from the light incident side.

The photoelectric conversion section 62 includes an upper electrode 62a, a photoelectric conversion layer 62b, a charge storage layer 62c, lower electrodes 62d and 62e, and an insulating layer 62f. In the photoelectric conversion section 62, the upper electrode 62a, the photoelectric conversion layer 62b, the charge storage layer 62c, the insulating layer 62f, and the lower electrodes 62d and 62e are stacked in order from the light incident side.

The photoelectric conversion layer 62b is made of an organic semiconductor material and photoelectrically converts light in a selective wavelength region (for example, an infrared wavelength region (hereinafter also referred to as "infrared region")) in the incident light L from the outside. The infrared wavelength region (the infrared region) is an example of a fourth wavelength region. That is, in the second embodiment, the photoelectric conversion section 62 photoelectrically converts the light in the infrared region. In the second embodiment, the photoelectric conversion section 62 is an example of a fourth photoelectric conversion section.

In the second embodiment, the light in the infrared region (infrared light) is absorbed by the photoelectric conversion section 62 located closest to the light incident side among the plurality of photoelectric conversion sections and is photoelectrically converted by such a photoelectric conversion section 62. In the second embodiment, since the infrared light focused on the photoelectric conversion section 62 corresponding to the OCL 71 can be made incident by the OCL 71, the sensitivity of the photoelectric conversion section 62 is improved.

As in the first embodiment explained above, in the second embodiment, the color splitter CS1 of the color splitter layer 50 makes the red light $L_R$ (see FIG. 6) incident on the photodiode group PD1A near (that is, present immediately below) the color splitter CS1.

The color splitter CS2 adjacent to the color splitter CS1 makes the red light $L_R$ incident on the photodiode group PD1A adjacent to (that is, adjacent to the photodiode group PD2A present immediately below) the color splitter CS2.

Furthermore, the color splitter CS3 adjacent to the color splitter CS1 makes the red light $L_R$ incident on the photodiode group PD1A adjacent to (that is, adjacent to the photodiode group PD3A present immediately below) the color splitter CS3.

That is, in the second embodiment, the focused red light $L_R$ is made incident on the photodiode group PD1A from a color splitter region configured by the color splitter CS1 immediately above the photodiode group PD1A and the plurality of color splitters CS2 and CS3 adjacent to the color splitter CS1 immediately above the photodiode group PD1A.

Therefore, in the second embodiment, it is possible to improve the sensitivity of the photodiode group PD1A that photoelectrically converts the red light $L_R$.

In the second embodiment, the color splitter CS2 of the color splitter layer 50 makes the blue light $L_B$ (see FIG. 7) incident on the photodiode group PD2A near (that is, present immediately below) the color splitter CS2.

The color splitter CS1 adjacent to the color splitter CS2 makes the blue light $L_B$ incident on the photodiode group PD2A adjacent to (that is, adjacent to the photodiode group PD1A present immediately below) the color splitter CS1.

Furthermore, the color splitter CS3 adjacent to the color splitter CS2 makes the blue light $L_B$ incident on the photodiode group PD2A adjacent to (adjacent to the photodiode group PD3A present immediately below) the color splitter CS3.

That is, in the second embodiment, the focused blue light $L_B$ is made incident on the photodiode group PD2A from a color splitter region configured by the color splitter CS2 immediately above the photodiode group PD2A and the plurality of color splitters CS1 and CS3 adjacent to the color splitter CS2 immediately above the photodiode group PD2A.

Therefore, in the second embodiment, it is possible to improve the sensitivity of the photodiode group PD2A that photoelectrically converts the blue light $L_B$.

In the second embodiment, the color splitter CS3 of the color splitter layer 50 makes the green light $L_G$ (see FIG. 5) incident on the photodiode group PD3A near (that is, present immediately below) the color splitter CS3.

The color splitter CS1 adjacent to the color splitter CS3 makes the green light $L_G$ incident on the photodiode group PD3A adjacent to (that is, adjacent to the photodiode group PD1A present immediately below) the color splitter CS1.

Furthermore, the color splitter CS2 adjacent to the color splitter CS3 makes the green light $L_G$ incident on the photodiode group PD3A adjacent to (that is, adjacent to the photodiode group PD2A present immediately below) the color splitter CS2.

That is, in the second embodiment, the focused green light $L_G$ is made incident on the photodiode group PD3A from a color splitter region configured by the color splitter CS3 immediately above the photodiode group PD3A and the plurality of color splitters CS1 and CS2 adjacent to the immediately upper color splitter CS3 immediately above the photodiode group PD3A.

Therefore, in the second embodiment, it is possible to improve the sensitivity of the photodiode group PD3A that photoelectrically converts the green light $L_G$.

As explained above, in the second embodiment, by disposing the color splitters CS1 to CS3 further on the light incident side than the photodiode groups PD1A to PD3A, it is possible to improve the sensitivity of the photodiode groups PD1A to PD3A.

Furthermore, in the second embodiment, the two photodiodes PD1 belonging to the same photodiode group PD1A are configured as photoelectric conversion sections capable of acquiring a phase difference of an image plane.

In this case, the two photodiodes PD1 belonging to the same photodiode group PD1A share a color splitter region in the same range configured by the color splitter CS1 immediately above the two photodiodes PD1 and the plurality of color splitters CS2 and CS3 adjacent to the color splitter CS1.

In the second embodiment, since the red light $L_R$ focused by the color splitter layer 50 is made incident on the photodiode group PD1A, it is possible to improve the detection sensitivity of the phase difference in the red light $L_R$.

Similarly, in the second embodiment, the two photodiodes PD2 belonging to the same photodiode group PD2A are configured as photoelectric conversion sections capable of acquiring a phase difference of an image plane.

In this case, the two photodiodes PD2 belonging to the same photodiode group PD2A share a color splitter region in the same range configured by the color splitter CS2 immediately above the two photodiodes PD2 and the plurality of color splitters CS1 and CS3 adjacent to the color splitter CS2.

In the second embodiment, since the blue light $L_B$ focused by the color splitter layer 50 is made incident on the photodiode group PD2A, it is possible to improve the detection sensitivity of a phase difference in the blue light $L_B$.

Similarly, in the second embodiment, the two photodiodes PD3 belonging to the same photodiode group PD3A are configured as photoelectric conversion sections capable of acquiring a phase difference of an image plane.

In this case, the two photodiodes PD3 belonging to the same photodiode group PD3A share a color splitter region in the same range configured by the color splitter CS3 immediately above the two photodiodes PD3 and the plurality of color splitters CS1 and CS2 adjacent to the color splitter CS3.

In the second embodiment, since the green light $L_G$ focused by the color splitter layer 50 is made incident on the photodiode group PD3A, it is possible to improve the detection sensitivity of a phase difference in the green light $L_G$.

That is, in the second embodiment, since the color splitter layer 50 can respectively focus light of all the RGB three colors, it is possible to improve the detection sensitivity of a phase difference in the light of all the RGB three colors.

In the second embodiment, since the photoelectric conversion section 62 that photoelectrically converts infrared light is provided further on the light incident side than the semiconductor layer 20, in addition to information concerning light of the RGB three colors reflected from a target object, information concerning infrared light reflected from the target object can also be acquired in the pixel region 3.

Note that, in the examples illustrated in FIG. 16 and FIG. 17, an example is explained in which the OCL layer 70 is provided at the position closest to the light incident side in the pixel region 3. However, the OCL layer 70 does not need to be always provided.

[Various modifications of the second embodiment]

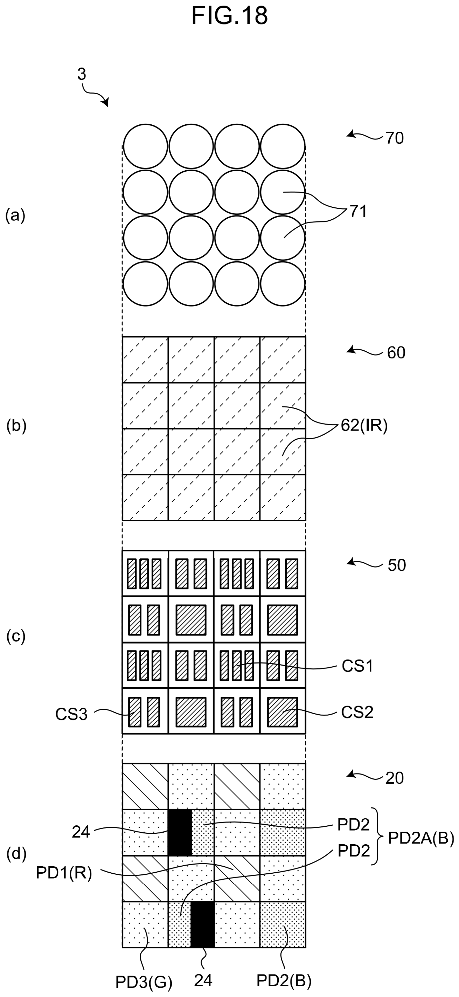

Subsequently, various modifications of the second embodiment are explained with reference to FIG. 18 to FIG. 29. FIG. 18 is a diagram for explaining a stacked structure and a planar structure of the pixel region 3 according to a modification 1 of the second embodiment of the present disclosure and is a diagram corresponding to FIG. 17 in the second embodiment.

As illustrated in FIG. 18, in the present modification 1, a configuration of the semiconductor layer 20 is different from that in the second embodiment explained above. Specifically, in the present modification 1, the photodiode groups PD1A to PD3A are not provided in most of the pixels 2 and one photodiode PD1, one photodiode PD2, or one photodiode PD3 is provided in most of the pixels 2.

On the other hand, the photodiode PD2, a light receiving area of which is halved by the light blocking film 24 located on one side (for example, the left side), is provided in a part of the pixels 2. Similarly, the photodiode PD2, a light receiving area of which is halved by the light blocking film 24 located on the other side (for example, the right side), is provided in another part of the pixels 2 close to the part of the pixels 2.

One photodiode group PD2A is configured by these two photodiodes PD2 having the halved areas. In the present modification 1, the two photodiodes PD2 belonging to the same photodiode group PD2A are configured as photoelectric conversion sections capable of acquiring a phase difference of an image plane.

Accordingly, it is possible to improve the sensitivity of the photodiode group PD2A that photoelectrically converts the blue light $L_B$ (see FIG. 7). Further, in the present modification 1, it is possible to improve the detection sensitivity of a phase difference in the blue light $L_B$.

Note that, in the example illustrated in FIG. 18, an example is explained in which one photodiode group PD2A is configured by the two photodiodes PD2, a light receiving area of which is halved. However, the present disclosure is not limited to such an example.

For example, one photodiode group PD1A (see FIG. 17) may be configured by two photodiodes PD1, a light receiving area of which is halved, and the two photodiodes PD1 may be configured as a photoelectric conversion section capable of acquiring a phase difference of an image plane. Accordingly, it is possible to improve the detection sensitivity of a phase difference in the red light $L_R$ (see FIG. 6).

One photodiode group PD3A (see FIG. 17) may be configured by the two photodiodes PD3, a light receiving area of which is halved, and such two photodiodes PD3 may be configured as photoelectric conversion sections capable of acquiring a phase difference of an image plane. Accordingly, it is possible to improve the detection sensitivity of a phase difference in the green light $L_G$ (see FIG. 5).

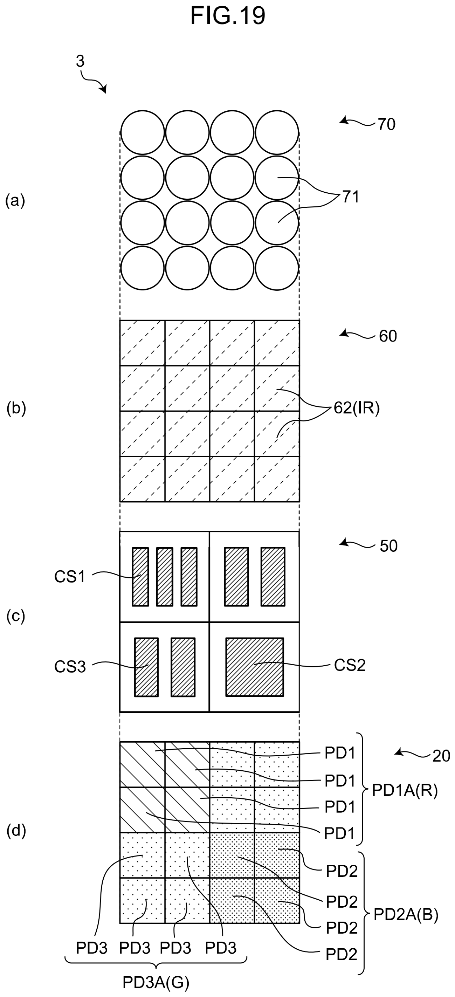

FIG. 19 is a diagram for explaining a stacked structure and a planar structure of the pixel region 3 according to a modification 2 of the second embodiment of the present disclosure. As illustrated in FIG. 19, in the present modification 2, configurations of the color splitter layer 50 and the semiconductor layer 20 are different from those in the second embodiment explained above (see FIG. 17).

In the present modification 2, the color splitters CS1 to CS3 having an area of two × two OCLs 71 are provided in the color splitter layer 50. On the back side of the color splitter CS1, two × two, that is, four photodiodes PD1 in total are located.

One photodiode group PD1A is configured by the four photodiodes PD1. Furthermore, in the present modification 2, the four photodiodes PD1 belonging to the same photodiode group PD1A are configured as photoelectric conversion sections capable of acquiring a phase difference of an image plane.

In this case, the four photodiodes PD1 belonging to the same photodiode group PD1A share a color splitter region in the same range configured by the color splitter CS1 immediately above the four photodiodes PD1 and the plurality of color splitters CS2 and CS3 adjacent to the color splitter CS1.

In the present modification 2, since the red light $L_R$ (see FIG. 6) focused by the color splitter layer 50 is made incident on the photodiode group PD1A, it is possible to improve the detection sensitivity of a phase difference in the red light $L_R$.

In the present modification 2, two × two, that is, four photodiodes PD2, in total are located on the back side of the color splitter CS2.

One photodiode group PD2A is configured by the four photodiodes PD2. Furthermore, in the present modification 2, the four photodiodes PD2 belonging to the same photodiode group PD2A are configured as photoelectric conversion sections capable of acquiring a phase difference of an image plane.

In this case, the four photodiodes PD2 belonging to the same photodiode group PD2A share a color splitter region in the same range configured by the color splitter CS2 immediately above the four photodiodes PD2 and the plurality of color splitters CS1 and CS3 adjacent to the color splitter CS2.

In the present modification 2, since the blue light $L_B$ (see FIG. 7) focused by the color splitter layer 50 is made incident on the photodiode group PD2A, it is possible to improve the detection sensitivity of a phase difference in the blue light $L_B$.

In the present modification 2, two × two, that is, four photodiodes PD3 in total are located on the back side of the color splitter CS3.

One photodiode group PD3A is configured by the four photodiodes PD3. Furthermore, in the present modification 2, the four photodiodes PD3 belonging to the same photodiode group PD3A are configured as photoelectric conversion sections capable of acquiring a phase difference of an image plane.

In this case, the four photodiodes PD3 belonging to the same photodiode group PD3A share a color splitter region in the same range including the color splitter CS3 immediately above the four photodiodes PD3 and the plurality of color splitters CS1 and CS2 adjacent to the color splitter CS3.

In the present modification 2, since the green light $L_G$ (see FIG. 5) focused by the color splitter layer 50 is made incident on the photodiode group PD3A, it is possible to improve the detection sensitivity of a phase difference in the green light $L_G$.

That is, in the present modification 2, since the color splitter layer 50 can respectively focus light of all the RGB three colors, it is possible to improve the detection sensitivity of a phase difference in the light of all the RGB three colors.

In the present modification 2, since the photodiode groups PD1A to PD3A respectively include two × two photodiodes PD1 to two × two photodiodes PD3, it is possible to measure the distance to a target object regardless of a texture direction and a color of the target object.

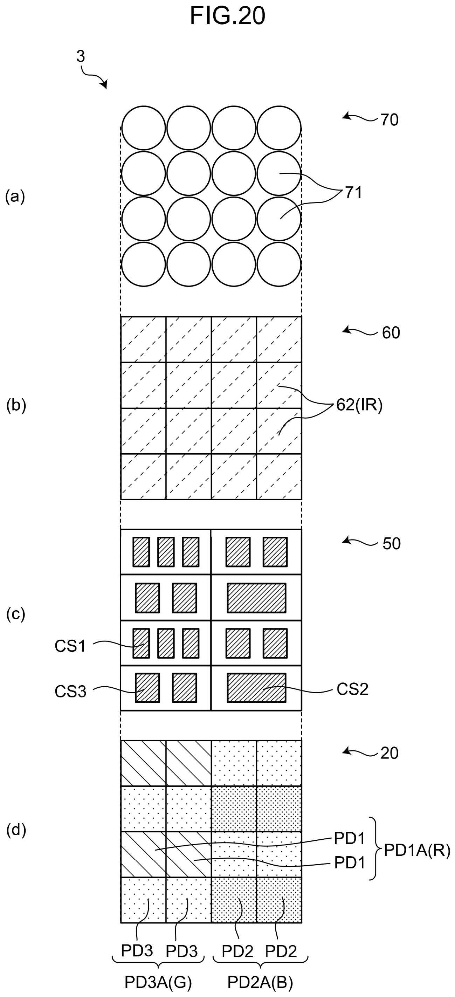

FIG. 20 is a diagram for explaining a stacked structure and a planar structure of the pixel region 3 according to a modification 3 of the second embodiment of the present disclosure. As illustrated in FIG. 20, in the present modification 3, configurations of the color splitter layer 50 and the semiconductor layer 20 are different from those in the second embodiment explained above (see FIG. 17).

Specifically, in the present modification 3, color splitters CS1, CS2, and CS3 having an area of two × one OCLs 71 are provided in the color splitter layer 50. Two × one, that is, two photodiodes PD1 in total are located on the back side of the color splitter CS1.

One photodiode group PD1A is configured by the two photodiodes PD1. Furthermore, in the present modification 3, the two photodiodes PD1 belonging to the same photodiode group PD1A are configured as photoelectric conversion sections capable of acquiring a phase difference of an image plane.

In this case, the two photodiodes PD1 belonging to the same photodiode group PD1A share a color splitter region in the same range configured by the color splitter CS1 immediately above the two photodiodes PD1 and the plurality of color splitters CS2 and CS3 adjacent to the color splitter CS1.

In the present modification 3, since the red light $L_R$ (see FIG. 6) focused by the color splitter layer 50 is made incident on the photodiode group PD1A, it is possible to improve the detection sensitivity of the phase difference in the red light $L_R$.

In the present modification 3, two × one, that is, two photodiodes PD2 in total are located on the back side of the color splitter CS2.

One photodiode group PD2A is configured by the two photodiodes PD2. Furthermore, in the present modification 3, the two photodiodes PD2 belonging to the same photodiode group PD2A are configured as photoelectric conversion sections capable of acquiring a phase difference of an image plane.

In this case, the two photodiodes PD2 belonging to the same photodiode group PD2A share a color splitter region in the same range configured by the color splitter CS2 immediately above the two photodiodes PD2 and the plurality of color splitters CS1 and CS3 adjacent to the color splitter CS2.

In the present modification 3, since the blue light $L_B$ (see FIG. 7) focused by the color splitter layer 50 is made incident on the photodiode group PD2A, it is possible to improve the detection sensitivity of the phase difference in the blue light $L_B$.

In the present modification 3, two × one, that is, two photodiodes PD3 in total are located on the back side of the color splitter CS3.

One photodiode group PD3A is configured by the two photodiodes PD3. Furthermore, in the present modification 3, the two photodiodes PD3 belonging to the same photodiode group PD3A are configured as photoelectric conversion sections capable of acquiring a phase difference of an image plane.

In this case, the two photodiodes PD3 belonging to the same photodiode group PD3A share a color splitter region in the same range configured by the color splitter CS3 immediately above the two photodiodes PD3 and the plurality of color splitters CS1 and CS2 adjacent to the color splitter CS3.

In the present modification 3, since the green light $L_G$ (see FIG. 5) focused by the color splitter layer 50 is made incident on the photodiode group PD3A, it is possible to improve the detection sensitivity of the phase difference in the green light $L_G$.

That is, in the present modification 3, since the color splitter layer 50 can respectively focus light of all the RGB three colors, it is possible to improve the detection sensitivity of a phase difference in the light of all the RGB three colors.

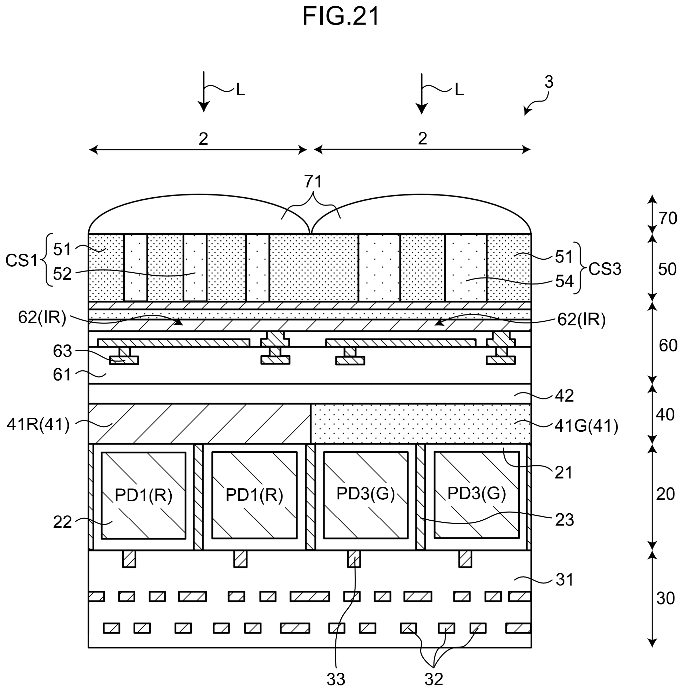

FIG. 21 is a cross-sectional view schematically illustrating a structure of the pixel region 3 according to a modification 4 of the second embodiment of the present disclosure. FIG. 17 is a diagram for explaining a stacked structure and a planar structure of the pixel region 3 according to the modification 4 of the second embodiment of the present disclosure.

As illustrated in FIG. 21 and the like, in the present modification 4, the order of stacking of layers is different from that in the second embodiment explained above (see FIG. 16). Specifically, in the pixel region 3 of the present modification 4, the OCL layer 70, the color splitter layer 50, the organic photoelectric conversion layer 60, the optical layer 40, the semiconductor layer 20, and the wiring layer 30 are stacked in order from the light incident side. That is, in the present modification 4, the color splitter layer 50 is located further on the light incident side than the organic photoelectric conversion layer 60.

Accordingly, by disposing the color splitters CS1 to CS3 further on the light incident side than the photodiode groups PD1A to PD3A, it is possible to improve the sensitivity of the photodiode groups PD1A to PD3A.

Furthermore, in the present modification 4, since the color splitter layer 50 can respectively focus light of all the RGB three colors, it is possible to improve the detection sensitivity of a phase difference in the light of all the RGB three colors.

In the present modification 4, since the photoelectric conversion section 62 that photoelectrically converts infrared light is provided further on the light incident side than the semiconductor layer 20, in addition to information concerning light of the RGB three colors reflected from a target object, information concerning the infrared light reflected from the target object can also be acquired in the pixel region 3.

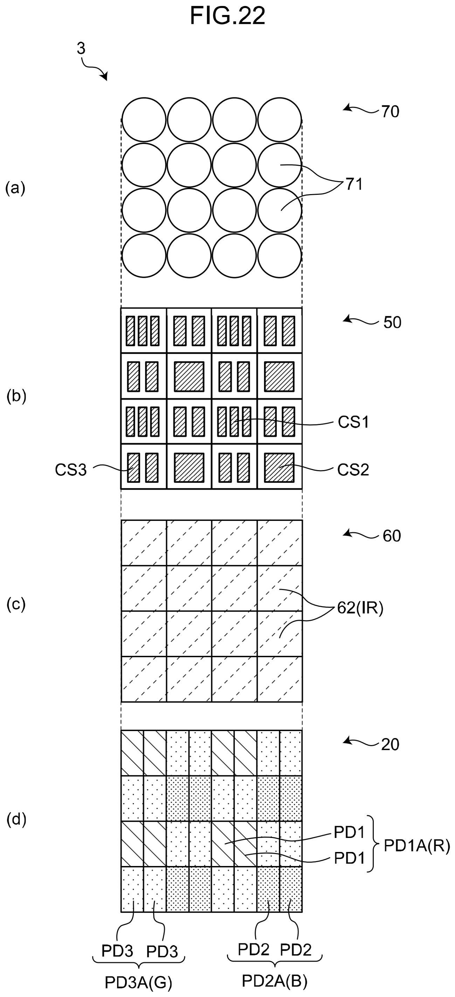

Note that, in the example illustrated in FIG. 22, an example is explained in which the color splitter layer 50 and the semiconductor layer 20 have the same configurations as those in the second embodiment explained above (see FIG. 17). However, the present disclosure is not limited to such an example. For example, in the example illustrated in FIG. 22, the semiconductor layer 20 may have the same configuration as that of the modification 1 explained above (see FIG. 18).

In the example illustrated in FIG. 22, the color splitter layer 50 and the semiconductor layer 20 may have the same configurations as those in the modification 2 explained above (see FIG. 19) and the color splitter layer 50 and the semiconductor layer 20 may have the same configurations as those in the modification 3 explained above (see FIG. 20).

In the examples illustrated in FIG. 18 to FIG. 22, an example is explained in which the OCL layer 70 is provided at the position closest to the light incident side in the pixel region 3. However, the OCL layer 70 does not need to be always provided.

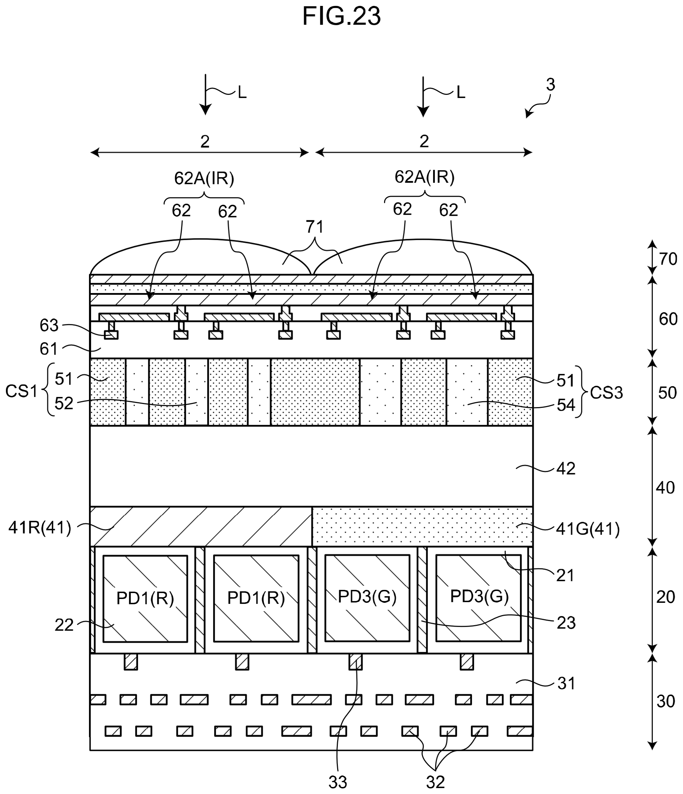

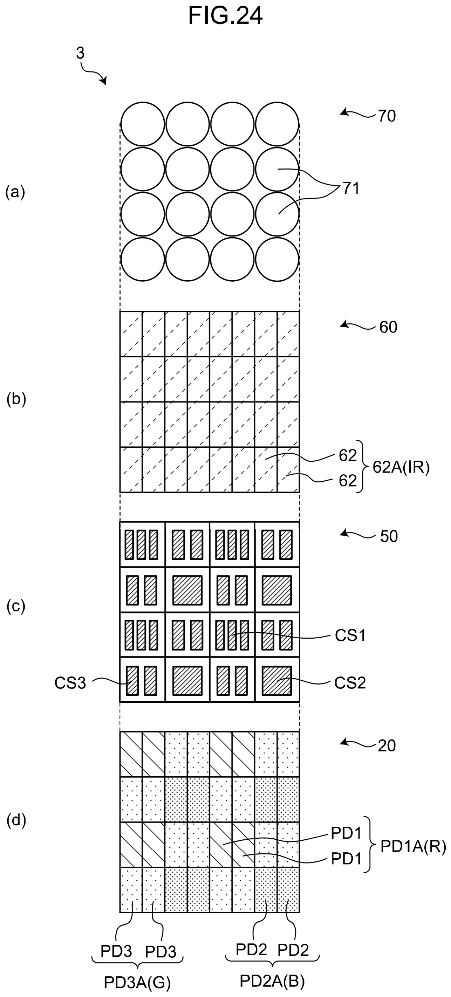

FIG. 23 is a cross-sectional view schematically illustrating a structure of the pixel region 3 according to a modification 5 of the second embodiment of the present disclosure. FIG. 24 is a diagram for explaining a stacked structure and a planar structure of the pixel region 3 according to the modification 5 of the second embodiment of the present disclosure.

As illustrated in FIG. 23 and FIG. 24, in the present modification 5, a configuration of the organic photoelectric conversion layer 60 is different from that in the second embodiment explained above (see FIG. 16 and FIG. 17). Specifically, in the present modification 5, two photoelectric conversion sections 62 are located on the back side of one OCL 71 and one photoelectric conversion section group 62A is configured by such two photoelectric conversion sections 62.

In the present modification 5, the two photoelectric conversion sections 62 belonging to the same photoelectric conversion section group 62A are configured as photoelectric conversion sections capable of acquiring a phase difference of an image plane. In this case, the two photoelectric conversion sections 62 belonging to the same photoelectric conversion section group 62A share the OCL 71 immediately above the two photoelectric conversion sections 62.

In the present modification 5, since infrared light focused by the OCL 71 is made incident on the photoelectric conversion section group 62A, it is possible to improve the detection sensitivity of a phase difference in the infrared light.

That is, in the present modification 5, since the OCL 71 and the color splitter layer 50 can respectively focus light of the RGB three colors and infrared light, it is possible to improve the detection sensitivity of a phase difference in the light of the RGB three colors and the infrared light.

Note that, in the example illustrated in FIG. 24, an example is explained in which the color splitter layer 50 and the semiconductor layer 20 have the same configurations as those in the second embodiment explained above (see FIG. 17). However, the present disclosure is not limited to such an example. For example, in the example illustrated in FIG. 24, the semiconductor layer 20 may have the same configuration as that in the modification 1 explained above (see FIG. 18).

In the example illustrated in FIG. 24, the color splitter layer 50 and the semiconductor layer 20 may have the same configurations as those in the modification 2 explained above (see FIG. 19) and the color splitter layer 50 and the semiconductor layer 20 may have the same configurations as those in the modification 3 explained above (see FIG. 20).

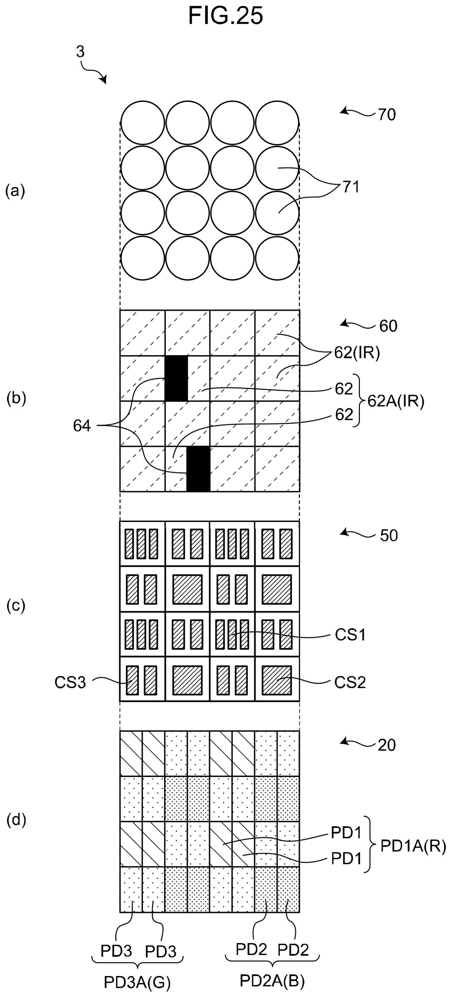

FIG. 25 is a diagram for explaining a stacked structure and a planar structure of the pixel region 3 according to a modification 6 of the second embodiment of the present disclosure. As illustrated in FIG. 25, in the present modification 6, a configuration of the organic photoelectric conversion layer 60 is different from that in the modification 5 (see FIG. 24) of the second embodiment explained above.

Specifically, in the present modification 6, the photoelectric conversion section group 62A is not provided in most of the pixels 2 and one photoelectric conversion section 62 is provided in most of the pixels 2.

On the other hand, the photoelectric conversion section 62, a light receiving area of which is halved by the light blocking film 64 located on one side (for example, the left side), is provided in a part of the pixels 2. Similarly, the photoelectric conversion section 62, a light receiving area of which is halved by the light blocking film 64 located on the other side (for example, the right side), is provided in another part of the pixels 2 close to the part of the pixels 2.

One photoelectric conversion section group 62A is configured by these two photoelectric conversion sections 62 having the halved area. Furthermore, in the present modification 6, the two photoelectric conversion sections 62 belonging to the same photoelectric conversion section group 62A are configured as photoelectric conversion sections capable of acquiring a phase difference of an image plane.

Here, in the present modification 6, since infrared light focused by the OCL 71 is made incident on the photoelectric conversion section group 62A, it is possible to improve the detection sensitivity of a phase difference in the infrared light.

That is, in the modification 6, since the OCL 71 and the color splitter layer 50 can respectively focus light of the RGB three colors and infrared light, it is possible to improve the detection sensitivity of a phase difference in the light of the RGB three colors and the infrared light.

Note that, in the example illustrated in FIG. 25, an example is explained in which the color splitter layer 50 and the semiconductor layer 20 have the same configurations as those in the second embodiment explained above (see FIG. 17). However, the present disclosure is not limited to such an example. For example, in the example illustrated in FIG. 25, the semiconductor layer 20 may have the same configuration as that in the modification 1 explained above (see FIG. 18).

In the example illustrated in FIG. 25, the color splitter layer 50 and the semiconductor layer 20 may have the same configurations as those in the modification 2 explained above (see FIG. 19) and the color splitter layer 50 and the semiconductor layer 20 may have the same configurations as those in the modification 3 explained above (see FIG. 20).

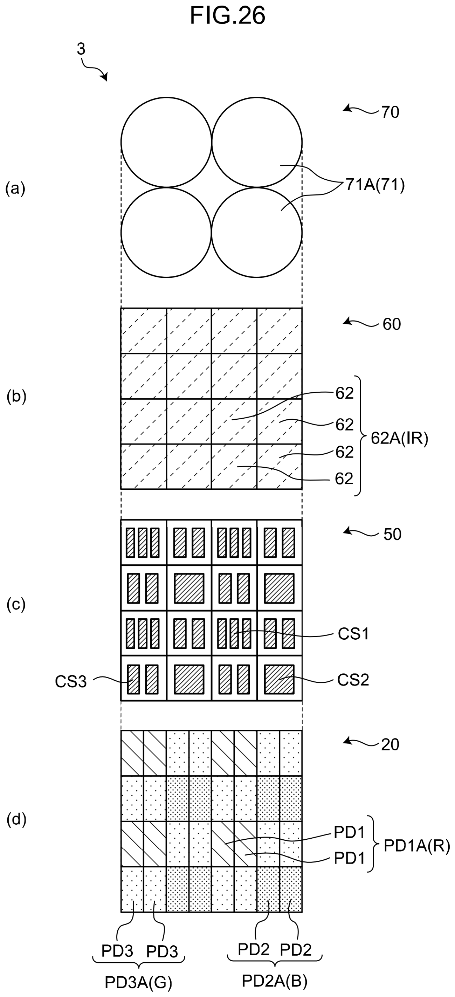

FIG. 26 is a diagram for explaining a stacked structure and a planar structure of the pixel region 3 according to a modification 7 of the second embodiment of the present disclosure. As illustrated in FIG. 26, in the present modification 7, the configurations of the OCL layer 70 and the organic photoelectric conversion layer 60 are different from those in the modification 5 of the second embodiment (see FIG. 24).

Specifically, in the present modification 7, a plurality of OCLs 71A having an area of two × two pixels 2 (see FIG. 16) are provided side by side in the OCL layer 70 in a matrix. Two × two, that is, four photoelectric conversion sections 62 in total are located on the back side of one OCL 71A.

One photoelectric conversion section group 62A is configured by the four photoelectric conversion sections 62. Furthermore, in the present modification 7, the four photoelectric conversion sections 62 belonging to the same photoelectric conversion section group 62A are configured as photoelectric conversion sections capable of acquiring a phase difference of an image plane. In this case, the four photoelectric conversion sections 62 belonging to the same photoelectric conversion section group 62A share the OCL 71A immediately above the four photoelectric conversion sections 62.

In the present modification 7, since infrared light focused by the OCL 71A is made incident on the photoelectric conversion section group 62A, it is possible to improve the detection sensitivity of a phase difference in the infrared light.

That is, in the present modification 7, since the OCL 71A and the color splitter layer 50 can respectively focus light of the RGB three colors and infrared light, it is possible to improve the detection sensitivity of a phase difference in the light of the RGB three colors and the infrared light.

Note that, in the example illustrated in FIG. 26, an example is explained in which the color splitter layer 50 and the semiconductor layer 20 have the same configuration as those in the second embodiment explained above (see FIG. 17). However, the present disclosure is not limited to such an example. For example, in the example illustrated in FIG. 26, the semiconductor layer 20 may have the same configuration as that in the modification 1 explained above (see FIG. 18).

In the example illustrated in FIG. 26, the color splitter layer 50 and the semiconductor layer 20 may have the same configurations as those in the modification 2 explained above (see FIG. 19) and the color splitter layer 50 and the semiconductor layer 20 may have the same configurations as those in the modification 3 explained above (see FIG. 20).

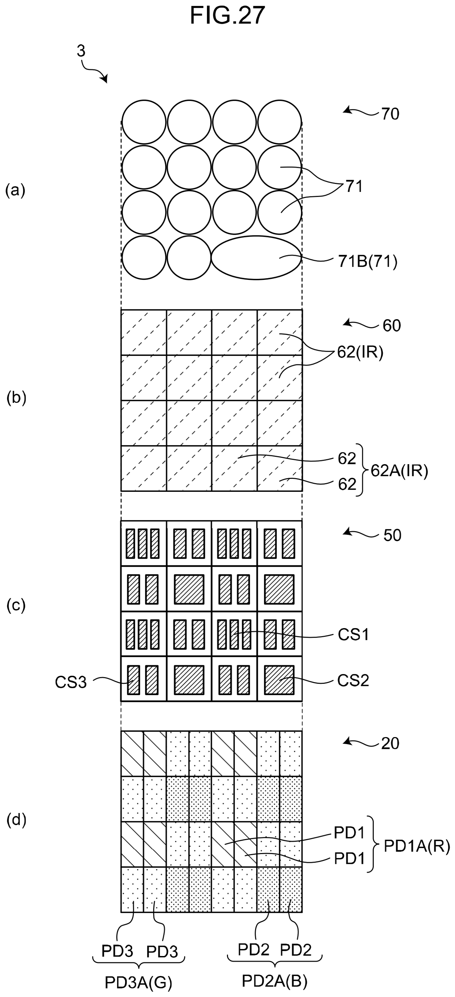

FIG. 27 is a diagram for explaining a stacked structure and a planar structure of the pixel region 3 according to a modification 8 of the second embodiment of the present disclosure. As illustrated in FIG. 27, in the present modification 8, a configuration of the OCL layer 70 is different from that in the second embodiment explained above.

Specifically, in the present modification 8, a semi-elliptical spherical OCL 71B having an area of two × one pixels 2 (see FIG. 16) is provided in a part of the OCL layer 70. Two × one, that is, two photoelectric conversion sections 62 in total are located on the back side of the OCL 71B.

One photoelectric conversion section group 62A is configured by the two photoelectric conversion sections 62. Furthermore, in the present modification 8, the two photoelectric conversion sections 62 belonging to the same photoelectric conversion section group 62A are configured as photoelectric conversion sections capable of acquiring a phase difference of an image plane. In this case, the two photoelectric conversion sections 62 belonging to the same photoelectric conversion section group 62A share the OCL 71B immediately above the two photoelectric conversion sections 62.

In the present modification 8, since infrared light focused by the OCL 71B is made incident on the photoelectric conversion section group 62A, it is possible to improve the detection sensitivity of a phase difference in the infrared light.

That is, in the present modification 8, since the OCL 71B and the color splitter layer 50 can respectively focus light of the RGB three colors and infrared light, it is possible to improve the detection sensitivity of a phase difference in the light of the RGB three colors and the infrared light.

Note that, in the example illustrated in FIG. 27, an example is explained in which the color splitter layer 50 and the semiconductor layer 20 have the same configurations as those in the second embodiment explained above (see FIG. 17). However, the present disclosure is not limited to such an example. For example, in the example illustrated in FIG. 27, the semiconductor layer 20 may have the same configuration as that in the modification 1 explained above (see FIG. 18).

In the example illustrated in FIG. 27, the color splitter layer 50 and the semiconductor layer 20 may have the same configurations as those in the modification 2 explained above (see FIG. 19) and the color splitter layer 50 and the semiconductor layer 20 may have the same configurations as those in the modification 3 explained above (see FIG. 20).

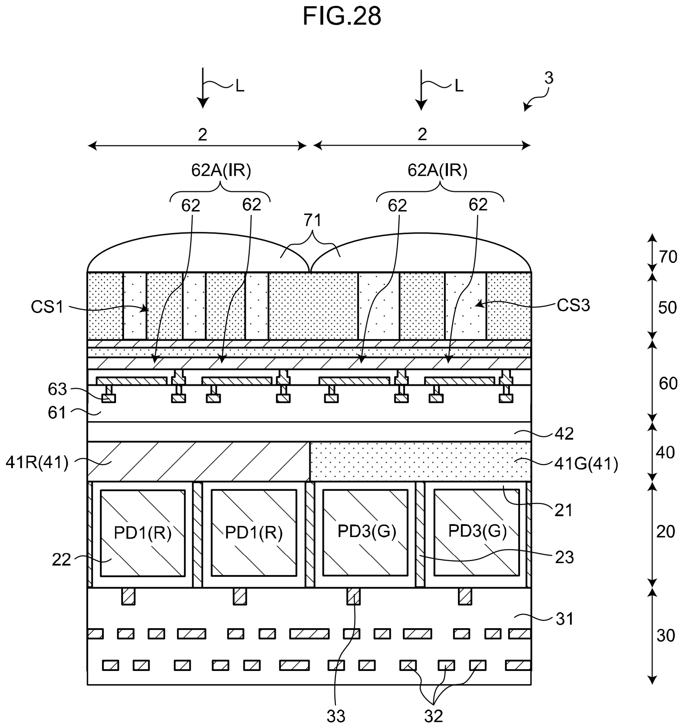

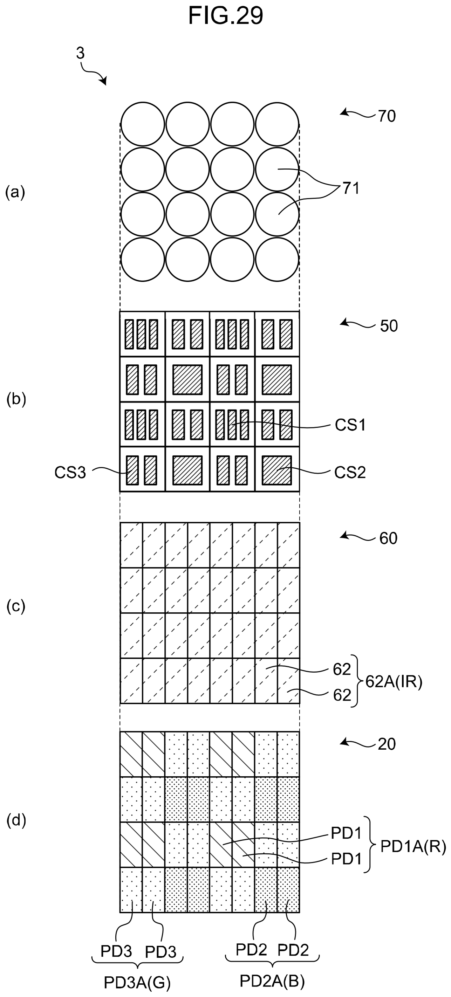

FIG. 28 is a cross-sectional view schematically illustrating a structure of the pixel region 3 according to a modification 9 of the second embodiment of the present disclosure. FIG. 29 is a diagram for explaining a stacked structure and a planar structure of the pixel region 3 according to the modification 9 of the second embodiment of the present disclosure.

As illustrated in FIG. 28 and the like, in the present modification 9, stacking order of the layers is different from that in the modification 5 (see FIG. 23 and the like) explained above. Specifically, in the pixel region 3 of the present modification 9, the OCL layer 70, the color splitter layer 50, the organic photoelectric conversion layer 60, the optical layer 40, the semiconductor layer 20, and the wiring layer 30 are stacked in order from the light incident side. That is, in the present modification 9, the color splitter layer 50 is located further on the light incident side than the organic photoelectric conversion layer 60.

Accordingly, by disposing the color splitters CS1 to CS3 further on the light incident side than the photodiode groups PD1A to PD3A, it is possible to improve the sensitivity of the photodiode groups PD1A to PD3A.

Furthermore, in the present modification 9, since the OCL 71 and the color splitter layer 50 can respectively focus light of the RGB three colors and infrared light, it is possible to improve the detection sensitivity of a phase difference in the light of the RGB three colors and the infrared light.

Note that, in the example illustrated in FIG. 29, an example is explained in which the color splitter layer 50 and the semiconductor layer 20 have the same configurations as those in the second embodiment explained above (see FIG. 17). However, the present disclosure is not limited to such an example. For example, in the example illustrated in FIG. 29, the semiconductor layer 20 may have the same configuration as that in the modification 1 explained above (see FIG. 18).

In the example illustrated in FIG. 29, the color splitter layer 50 and the semiconductor layer 20 may have the same configurations as those in the modification 2 explained above (see FIG. 19) and the color splitter layer 50 and the semiconductor layer 20 may have the same configurations as those in the modification 3 explained above (see FIG. 20).

[Third Embodiment]

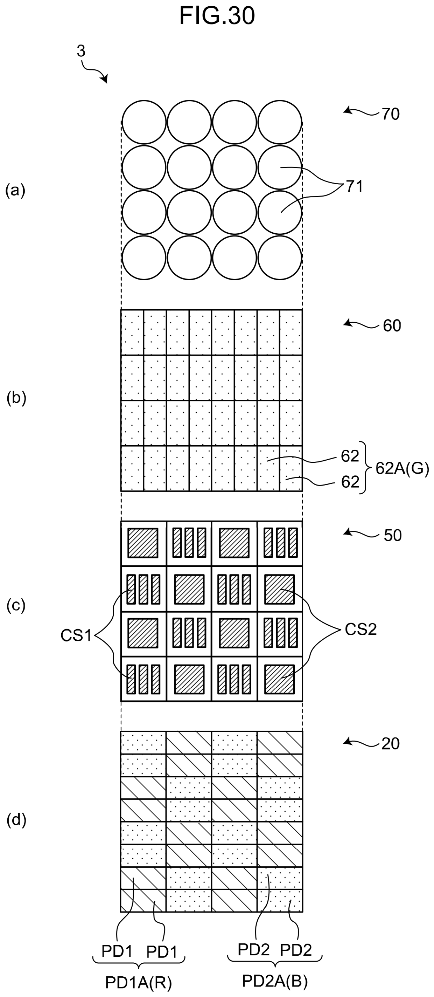

FIG. 30 is a diagram for explaining a stacked structure and a planar structure of the pixel region 3 according to a third embodiment of the present disclosure. As illustrated in FIG. 30, a basic layer structure in the third embodiment is the same as that in the modification 4 (see FIG. 12) of the first embodiment explained above.

In the third embodiment, a dividing direction of the two photodiodes PD1 in the photodiode group PD1A located in the semiconductor layer 20 and a dividing direction of the two photoelectric conversion sections 62 in the photoelectric conversion section group 62A located in the organic photoelectric conversion layer 60 intersect each other.

Similarly, in the third embodiment, a dividing direction of the two photodiodes PD2 in the photodiode group PD2A located in the semiconductor layer 20 and a dividing direction of the two photoelectric conversion sections 62 in the photoelectric conversion section group 62A located in the organic photoelectric conversion layer 60 intersect each other.

For example, in the example illustrated in FIG. 30, all photodiode groups PD1A and all photodiode groups PD2A are divided in the longitudinal direction and all photoelectric conversion section groups 62A are divided in the lateral direction.

Accordingly, since the same function as the function in the case in which two × two photoelectric conversion sections sharing an optical system are located in one pixel 2 (see FIG. 11) can be imparted to the pixel region 3, it is possible to measure the distance to a target object regardless of a texture direction or a color of the target object.

In the third embodiment, since a pixel size can be increased compared with the case in which two × two pixels 2 share an optical system, it is possible to improve pixel performance such as sensitivity.

In the example illustrated in FIG. 30, an example is explained in which all the photodiode groups PD1A and PD2A are divided in the longitudinal direction and all the photoelectric conversion section groups 62A are divided in the lateral direction. However, the present disclosure is not limited to such an example.

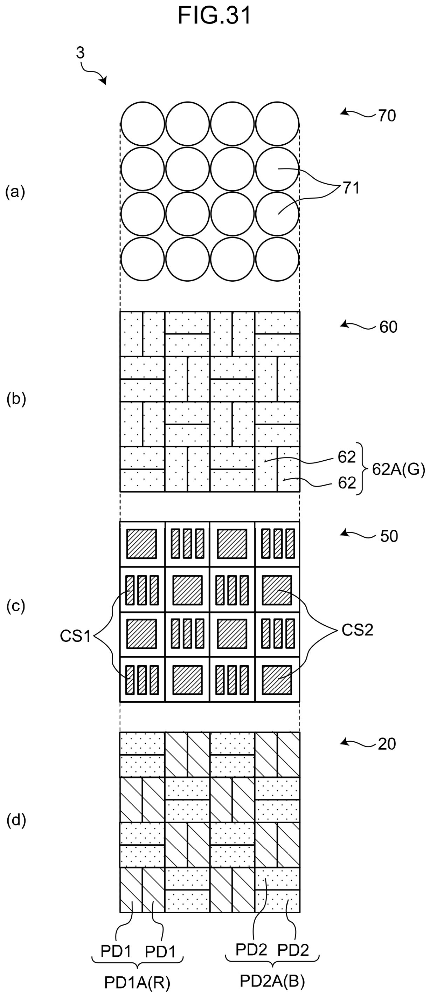

FIG. 31 is a diagram for explaining a stacked structure and a planar structure of the pixel region 3 according to the modification 1 of the third embodiment of the present disclosure. As illustrated in FIG. 31, in the present modification 1, the dividing directions of all the photodiode groups PD1A and the dividing directions of all the photodiode groups PD2A are different.

For example, in the example illustrated in FIG. 31, all the photodiode groups PD1A are divided in the lateral direction and all the photodiode groups PD2A are divided in the longitudinal direction.

In the present modification 1, a dividing direction of the photoelectric conversion section group 62A located immediately above the photodiode group PD1A is different from a dividing direction of the photodiode group PD1A. Similarly, in the present modification 1, a dividing direction of the photoelectric conversion section group 62A located immediately above the photodiode group PD2A is different from a dividing direction of the photodiode group PD2A.

For example, in the example illustrated in FIG. 31, the photoelectric conversion section group 62A located immediately above the photodiode group PD1A is divided in the longitudinal direction and the photoelectric conversion section group 62A located immediately above the photodiode group PD2A is divided in the lateral direction.

Accordingly, since the same function as a function in the case in which two × two photoelectric conversion sections sharing an optical system are located in one pixel 2 (see FIG. 11) can be imparted to the pixel region 3, it is possible to measure the distance to a target object regardless of a texture direction or a color of the object.

In the present modification 1, a pixel size can be increased compared with the case in which two × two pixels 2 share the optical system. Therefore, it is possible to improve pixel performance such as sensitivity.

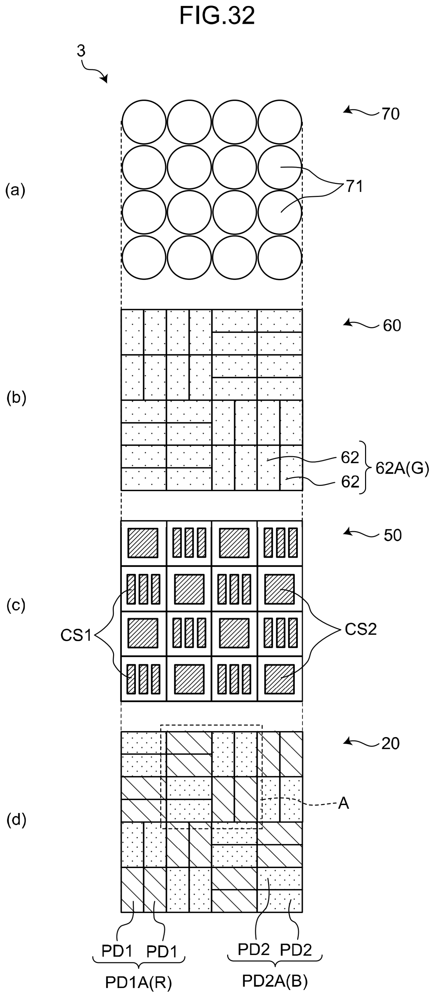

FIG. 32 is a diagram for explaining a stacked structure and a planar structure of the pixel region 3 according to a modification 2 of the third embodiment of the present disclosure. As illustrated in (b) of FIG. 32, in the present modification 2, a region of two × two pixels 2 (see FIG. 11) into which the photoelectric conversion section group 62A is divided into upper and lower parts and a region of two × two pixels 2 into which the photoelectric conversion section group 62A is divided into left and right parts are disposed side by side in a checkered pattern.

In the present modification 2, as illustrated in (d) of FIG. 32, the dividing direction of the photodiode groups PD1A and PD2A located on the back side of the photoelectric conversion section group 62A is different from a dividing direction of the photoelectric conversion section group 62A.

For example, in the example illustrated in FIG. 32, the photodiode groups PD1A and PD2A located on the back side of the photoelectric conversion section group 62A divided in the lateral direction are divided in the longitudinal direction. Similarly, in the example illustrated in FIG. 32, the photodiode groups PD1A and PD2A located on the back side of the photoelectric conversion section group 62A divided in the longitudinal direction are divided in the lateral direction.

Accordingly, since the same function as a function in the case in which two × two photoelectric conversion sections sharing the optical system are located in one pixel 2 can be imparted to the pixel region 3, it is possible to measure the distance to a target object regardless of a texture direction or a color of the target object.

In the present modification 2, since a pixel size can be increased compared with the case in which two × two pixels 2 share the optical system, it is possible to improve pixel performance such as sensitivity.

In the present modification 2, in a region A of two × two pixels 2 illustrated in (d) of FIG. 32, two photodiode groups PD1A are divided respectively in the longitudinal direction and the lateral direction and two photodiode groups PD2A are divided in the longitudinal direction and the lateral direction.

Accordingly, when the pixels 2 are thinned out and subjected to signal processing, it is possible to measure the distance to a target object regardless of a texture direction and a color of the target object in light of all the RGB three colors.

[Fourth Embodiment]

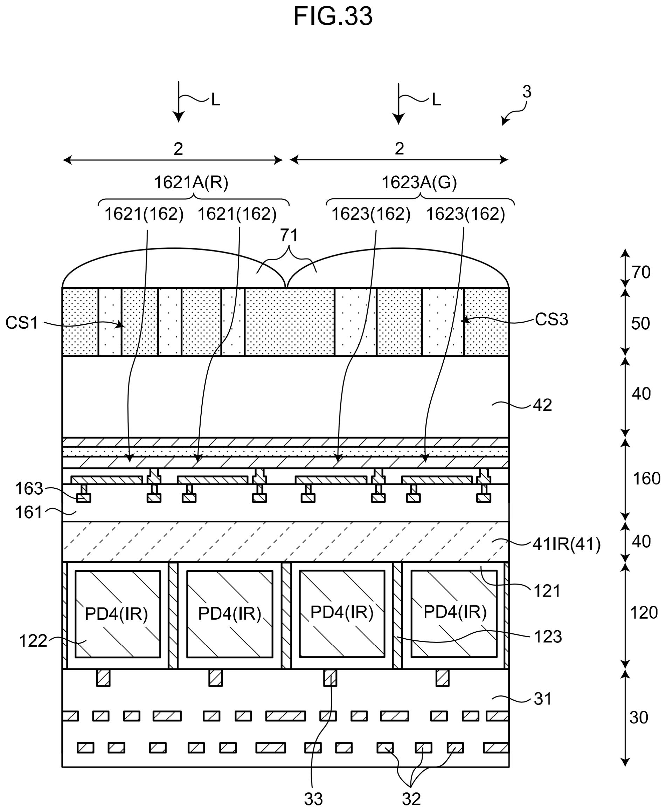

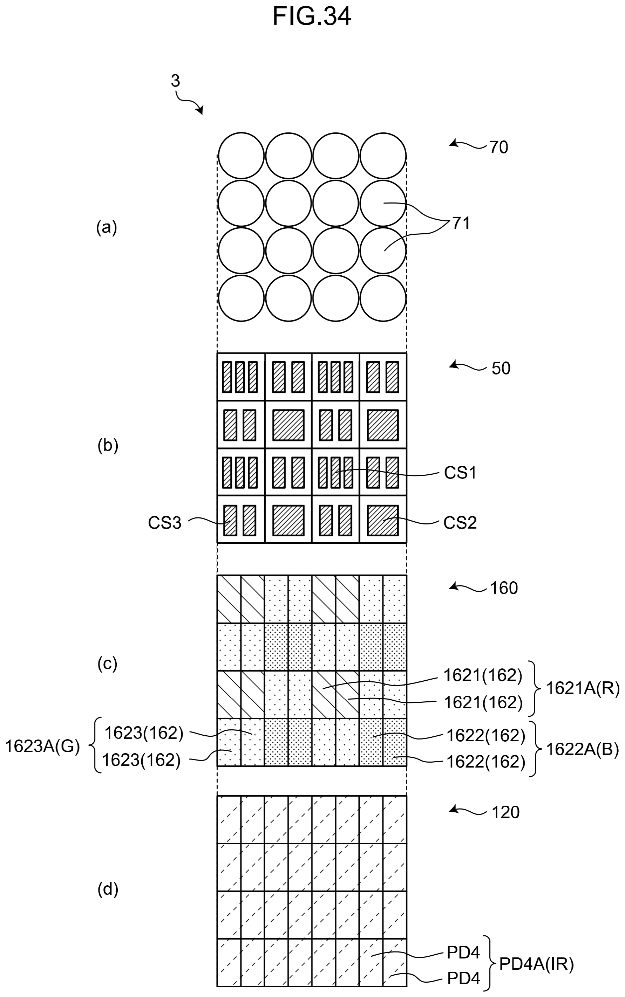

Subsequently, a detailed configuration of the pixel region 3 according to a fourth embodiment is explained with reference to FIG. 33 and FIG. 34. FIG. 33 is a cross-sectional view schematically illustrating a structure of the pixel region 3 according to the fourth embodiment of the present disclosure. FIG. 34 is a diagram for explaining a stacked structure and a planar structure of the pixel region 3 according to the fourth embodiment of the present disclosure.

The pixel region 3 in the fourth embodiment includes a semiconductor layer 120, the wiring layer 30, the optical layer 40, the color splitter layer 50, an organic photoelectric conversion layer 160, and the OCL layer 70. The semiconductor layer 120 is an example of another photoelectric conversion layer and the organic photoelectric conversion layer 160 is an example of a photoelectric conversion layer.

In the pixel region 3, the OCL layer 70, the color splitter layer 50, the buffer layer 42 of the optical layer 40, the organic photoelectric conversion layer 160, the color filter 41 of the optical layer 40, the semiconductor layer 120, and the wiring layer 30 are stacked in order from the light incident side.

The semiconductor layer 120 includes a semiconductor region 121 of the first conductivity type (for example, P-type), semiconductor regions 122 of the second conductivity type (for example, N-type), and a separation section 123. In the semiconductor region 121 of the first conductivity type, the semiconductor regions 122 of the second conductivity type are formed side by side in a plane direction (an array direction of the pixels 2) in units of pixels, whereby the photodiodes PD4 by PN junctions are formed side by side in the plane direction. The photodiode PD4 is an example of another photoelectric conversion section and a fourth photoelectric conversion section.

For example, the photodiode PD4 is a photoelectric conversion section that receives and photoelectrically converts light in an infrared region. That is, in the fourth embodiment, the semiconductor layer 120 photoelectrically converts infrared light.

In the fourth embodiment, as illustrated in (d) of FIG. 34, a photodiode group PD4A is configured by two photodiodes PD4 adjacent to each other. The photodiode group PD4A is an example of another photoelectric conversion section group. For example, the photodiode group PD4A is individually formed for each of the pixels 2 (see FIG. 33) in the pixel region 3.

FIG. 33 is referred back. The separation section 123 of the semiconductor layer 120 electrically and optically separates the adjacent photodiodes PD4 from each other. Note that, in the present disclosure, the photodiodes PD4 belonging to the same photodiode group PD4A may be electrically connected to each other by an overflow path.

The color filter 41 of the optical layer 40 is located on the surface on the light incident side in the semiconductor layer 120. The color filter 41 is an optical filter that transmits light in a predetermined wavelength region in the incident light L. In the fourth embodiment, the color filter 41 is configured by a color filter 41IR that transmits infrared light.

The organic photoelectric conversion layer 160 is disposed on the surface on the light incident side in the color filter 41. The organic photoelectric conversion layer 160 includes an interlayer insulating film 161 and a photoelectric conversion section 162. Since a configuration of the photoelectric conversion section 162 is the same as that in the second embodiment and the like explained above, detailed explanation of a film configuration is omitted.

In the fourth embodiment, the photoelectric conversion section 162 includes a photoelectric conversion section 1621, a photoelectric conversion section 1622 (see FIG. 34), and a photoelectric conversion section 1623. The photoelectric conversion section 1621 is an example of a first photoelectric conversion section, the photoelectric conversion section 1622 is an example of a second photoelectric conversion section, and the photoelectric conversion section 1623 is an example of a third photoelectric conversion section.

For example, the photoelectric conversion section 1621 is a photoelectric conversion section that receives and photoelectrically converts light in the red region. The photoelectric conversion section 1622 is a photoelectric conversion section that receives and photoelectrically converts light in the blue region. The photoelectric conversion section 1623 is a photoelectric conversion section that receives and photoelectrically converts light in the green region. That is, in the fourth embodiment, the organic photoelectric conversion layer 160 photoelectrically converts light of RGB three colors.

In the fourth embodiment, as illustrated in (c) of FIG. 34, a photoelectric conversion section group 1621A is configured by two photoelectric conversion sections 1621 adjacent to each other. A photoelectric conversion section group 1622A is configured by two photoelectric conversion sections 1622 adjacent to each other and a photoelectric conversion section group 1623A is configured by two photoelectric conversion sections 1623 adjacent to each other.

In the organic photoelectric conversion layer 160, for example, a plurality of photoelectric conversion section groups 1621A, a plurality of photoelectric conversion section groups 1622A, and a plurality of photoelectric conversion section groups 1623A are disposed in a so-called Bayer array. The photoelectric conversion section group 1621A, the photoelectric conversion section group 1622A, or the photoelectric conversion section group 1623A is, for example, individually formed for each of the pixels 2 (see FIG. 33) in the pixel region 3.

FIG. 33 is referred back. The buffer layer 42 of the optical layer 40 is disposed on the surface on the light incident side in the organic photoelectric conversion layer 160. The color splitter layer 50 is disposed on the surface on the light incident side in the buffer layer 42. The color splitter layer 50 includes the low refractive index section 51 (see FIG. 2), the high refractive index section 52 (see FIG. 2), the high refractive index section 53 (see FIG. 2), and the high refractive index section 54 (see FIG. 16).

The high refractive index sections 52, 53, and 54 are made of a material having a refractive index higher than that of the low refractive index section 51. The high refractive index section 52 has a predetermined planar shape on the inside of the color splitter layer 50 and is disposed on the light incident side of the photoelectric conversion section group 1621A. On the light incident side of the photoelectric conversion section group 1621A, the color splitter CS1 is configured by the low refractive index section 51 and the high refractive index section 52.

The high refractive index section 53 has a predetermined planar shape on the inside of the color splitter layer 50 and is disposed on the light incident side of the photoelectric conversion section group 1622A. On the light incident side of the photoelectric conversion section group 1622A, the color splitter CS2 (see FIG. 34) is configured by the low refractive index section 51 and the high refractive index section 53.

The high refractive index section 54 has a predetermined planar shape on the inside of the color splitter layer 50 and is disposed on the light incident side of the photoelectric conversion section group 1623A. On the light incident side of the photoelectric conversion section group 1623A, the color splitter CS3 is configured by the low refractive index section 51 and the high refractive index section 54.

For example, the color splitter CS1, the color splitter CS2, or the color splitter CS3 is individually formed for each of the pixels 2 (see FIG. 2) of the pixel region 3.

Then, in the fourth embodiment, the color splitter CS1 of the color splitter layer 50 makes the red light $L_R$ (see FIG. 6) incident on the photoelectric conversion section group 1621A near (that is, present immediately below) the color splitter CS1.

The color splitter CS2 adjacent to the color splitter CS1 makes the red light $L_R$ incident on the photoelectric conversion section group 1621A adjacent to (that is, adjacent to the photoelectric conversion section group 1622A present immediately below) the color splitter CS2.

Furthermore, the color splitter CS3 adjacent to the color splitter CS1 makes the red light $L_R$ incident on the photoelectric conversion section group 1621A adjacent to (that is, adjacent to the photoelectric conversion section group 1623A present immediately below) the color splitter CS3.

That is, in the fourth embodiment, the focused red light $L_R$ is made incident on the photoelectric conversion section group 1621A from a color splitter region configured by the color splitter CS1 immediately above the photoelectric conversion section group 1621A and the plurality of color splitters CS2 and CS3 adjacent to the immediately upper color splitter CS1.

Therefore, in the fourth embodiment, it is possible to improve the sensitivity of the photoelectric conversion section group 1621A that photoelectrically converts the red light $L_R$.

In the fourth embodiment, the color splitter CS2 of the color splitter layer 50 makes the blue light $L_B$ (see FIG. 7) incident on the photoelectric conversion section group 1622A near (that is, present immediately below) the color splitter CS2.

The color splitter CS1 adjacent to the color splitter CS2 makes the blue light $L_B$ incident on the photoelectric conversion section group 1622A adjacent to (that is, adjacent to the photoelectric conversion section group 1621A present immediately below) the color splitter CS1.

Furthermore, the color splitter CS3 adjacent to the color splitter CS2 makes the blue light $L_B$ incident on the photoelectric conversion section group 1622A adjacent to (that is, adjacent to the photoelectric conversion section group 1623A present immediately below) the color splitter CS3.

That is, in the fourth embodiment, the focused blue light $L_B$ is made incident on the photoelectric conversion section group 1622A from a color splitter region configured by the color splitter CS2 immediately above the photoelectric conversion section group 1622A and the plurality of color splitters CS1 and CS3 adjacent to the immediately upper color splitter CS2.

Therefore, in the fourth embodiment, it is possible to improve the sensitivity of the photoelectric conversion section group 1622A that photoelectrically converts the blue light $L_B$.

In the fourth embodiment, the color splitter CS3 of the color splitter layer 50 makes the green light $L_G$ (see FIG. 5) incident on the photoelectric conversion section group 1623A near (that is, present immediately below) the color splitter CS3.

The color splitter CS1 adjacent to the color splitter CS3 makes the green light $L_G$ incident on the photoelectric conversion section group 1623A adjacent to (that is, adjacent to the photoelectric conversion section group 1621A present immediately below) the color splitter CS1.

Furthermore, the color splitter CS2 adjacent to the color splitter CS3 makes the green light $L_G$ incident on the photoelectric conversion section group 1623A adjacent to (that is, adjacent to the photoelectric conversion section group 1622A present immediately below) the color splitter CS2.

That is, in the fourth embodiment, the focused green light $L_G$ is made incident on the photoelectric conversion section group 1623A from a color splitter region configured by the color splitter CS3 immediately above the photoelectric conversion section group 1623A and the plurality of color splitters CS1 and CS2 adjacent to the immediately upper color splitter CS3.

Therefore, in the fourth embodiment, it is possible to improve the sensitivity of the photoelectric conversion section group 1623A that photoelectrically converts the green light $L_G$.

As explained above, in the fourth embodiment, by disposing the color splitters CS1 to CS3 further on the light incident side than the photoelectric conversion section groups 1621A to 1623 A, it is possible to improve the sensitivity of the photoelectric conversion section groups 1621A to 1623 A.

Furthermore, in the fourth embodiment, the two photoelectric conversion sections 1621 belonging to the same photoelectric conversion section group 1621A are configured as photoelectric conversion sections capable of acquiring a phase difference of an image plane.

In this case, the two photoelectric conversion sections 1621 belonging to the same photoelectric conversion section group 1621A share a color splitter region in the same range configured by the color splitter CS1 immediately above the two photoelectric conversion sections 1621 and the plurality of color splitters CS2 and CS3 adjacent to such a color splitter CS1.

In the fourth embodiment, since the red light $L_R$ focused by the color splitter layer 50 is made incident on the photoelectric conversion section group 1621A, it is possible to improve the detection sensitivity of a phase difference in the red light $L_R$.

Similarly, in the fourth embodiment, the two photoelectric conversion sections 1622 belonging to the same photoelectric conversion section group 1622A are configured as photoelectric conversion sections capable of acquiring a phase difference of an image plane.

In this case, the two photoelectric conversion sections 1622 belonging to the same photoelectric conversion section group 1622A share a color splitter region in the same range configured by the color splitter CS2 immediately above the two photoelectric conversion sections 1622 and the plurality of color splitters CS1 and CS3 adjacent to such a color splitter CS2.

In the fourth embodiment, since the blue light $L_B$ focused by the color splitter layer 50 is made incident on the photoelectric conversion section group 1622A, it is possible to improve the detection sensitivity of a phase difference in the blue light $L_B$.

Similarly, in the fourth embodiment, the two photoelectric conversion sections 1623 belonging to the same photoelectric conversion section group 1623A are configured as photoelectric conversion sections capable of acquiring a phase difference of an image plane.

In this case, the two photoelectric conversion sections 1623 belonging to the same photoelectric conversion section group 1623A share a color splitter region in the same range configured by the color splitter CS3 immediately above the two photoelectric conversion sections 1623 and the plurality of color splitters CS1 and CS2 adjacent to such a color splitter CS3.

In the fourth embodiment, since the green light $L_G$ focused by the color splitter layer 50 is made incident on the photoelectric conversion section group 1623A, it is possible to improve the detection sensitivity of a phase difference in the green light $L_G$.

That is, in the fourth embodiment, since the color splitter layer 50 can respectively focus light of all the RGB three colors, it is possible to improve the detection sensitivity of a phase difference in the light of all the RGB three colors.

In the fourth embodiment, since the photodiode PD4 that photoelectrically converts infrared light is provided further on the back side than the organic photoelectric conversion layer 160, in addition to information concerning the light of the RGB three colors reflected from a target object, information concerning infrared light reflected from the target object can also be acquired in the pixel region 3.

In the fourth embodiment, since the photodiode group PD4A is provided in the semiconductor layer 120, it is possible to acquire a phase difference of an image plane in light of RGB three colors and the infrared light.

[Effects]

The photodetection device 1 according to the embodiment includes the photoelectric conversion layer (the semiconductor layer 20 and the organic photoelectric conversion layer 160) and the color splitter layer 50. The photoelectric conversion layer (the semiconductor layer 20 or the organic photoelectric conversion layer 160) includes the photoelectric conversion section group (the photodiode groups PD1A to PD3A or the photoelectric conversion section groups 1621A to 1623A) configured by the plurality of photoelectric conversion sections (the photodiodes PD1 to PD3 or the photoelectric conversion sections 1621 to 1623) capable of detecting phase differences among incident light beams made incident thereon. The color splitter layer 50 is located on the light incident side of the photoelectric conversion layer (the semiconductor layer 20 or the organic photoelectric conversion layer 160) and has a meta-surface structure.

Accordingly, in the photodetection device 1, it is possible to improve the detection sensitivity of a phase difference.

In addition, in the photodetection device 1 according to the embodiment, the photoelectric conversion section group (the photodiode groups PD1A to PD3A or the photoelectric conversion section groups 1621A to 1623A) is configured by the two photoelectric conversion sections (the photodiodes PD1 to PD3 or the photoelectric conversion sections 1621 to 1623).

Accordingly, it is possible to measure the distance to a target object.

In the photodetection device 1 according to the embodiment, the photoelectric conversion section group (the photodiode groups PD1A to PD3A or the photoelectric conversion section groups 1621A to 1623A) is configured by the four photoelectric conversion sections (the photodiodes PD1 to PD3 or the photoelectric conversion sections 1621 to 1623).

Accordingly, it is possible to measure the distance to a target object.

The photodetection device 1 according to the embodiment further includes the another photoelectric conversion layer (the organic photoelectric conversion layer 60) located further on the light incident side than the photoelectric conversion layer (the semiconductor layer 20) and including the plurality of other photoelectric conversion sections (the photoelectric conversion sections 62).

Accordingly, it is possible to acquire, in the pixel region 3, information concerning light in more wavelength regions reflected from a target object.

In the photodetection device 1 according to the embodiment, the another photoelectric conversion layer (the organic photoelectric conversion layer 60) includes the another photoelectric conversion section group (the photoelectric conversion section group 62A) including the plurality of other photoelectric conversion sections (the photoelectric conversion section 62) capable of detecting phase differences among incident light beams made incident thereon.

Accordingly, it is possible to acquire phase differences of image planes in light of more wavelength regions reflected from a target object.

In the photodetection device 1 according to the embodiment, the another photoelectric conversion section group (the photoelectric conversion section group 62A) is configured by the two other photoelectric conversion sections (the photoelectric conversion sections 62).

Accordingly, it is possible to measure the distance to a target object.

In the photodetection device 1 according to the embodiment, the another photoelectric conversion section group (the photoelectric conversion section group 62A) is configured by the four different photoelectric conversion sections (the photoelectric conversion sections 62).

Accordingly, it is possible to measure the distance to a target object.

In the photodetection device 1 according to the embodiment, the another photoelectric conversion layer (the organic photoelectric conversion layer 60) is located further on the light incident side than the color splitter layer 50.

Accordingly, it is possible to suppress occurrence of color mixing in the color splitter layer 50 and the semiconductor layer 20.

In the photodetection device 1 according to the embodiment, the color splitter layer 50 is located further on the light incident side than the another photoelectric conversion layer (the organic photoelectric conversion layer 60).

Accordingly, it is possible to suppress occurrence of color mixing in the semiconductor layer 20.

In the photodetection device 1 according to the embodiment, the photoelectric conversion layer (the semiconductor layer 20) includes the first photoelectric conversion section (the photodiode PD1) and the second photoelectric conversion section (the photodiode PD2). The first photoelectric conversion section (the photodiode PD1) photoelectrically converts light (the red light $L_R$) in the first wavelength region that is a visible region. The second photoelectric conversion section (the photodiode PD2) photoelectrically converts light (the blue light $L_B$) in the second wavelength region that is a visible region. In addition, the another photoelectric conversion layer (the organic photoelectric conversion layer 60) includes the third photoelectric conversion section (the photoelectric conversion section 62) that photoelectrically converts light (the green light $L_G$) in the third wavelength region that is a visible region.

Accordingly, it is possible to acquire, in the pixel region 3, information concerning light of the RGB three colors reflected from a target object.

In the photodetection device 1 according to the embodiment, the photoelectric conversion layer (the semiconductor layer 20) includes the first photoelectric conversion section (the photodiode PD1), the second photoelectric conversion section (the photodiode PD2), and the third photoelectric conversion section (the photodiode PD3). The first photoelectric conversion section (the photodiode PD1) photoelectrically converts light (the red light $L_R$) in the first wavelength region that is a visible region. The second photoelectric conversion section (the photodiode PD2) photoelectrically converts light (the blue light $L_B$) in the second wavelength region that is a visible region. The third photoelectric conversion section (the photodiode PD3) photoelectrically converts light (the green light $L_G$) in the third wavelength region that is a visible region. The another photoelectric conversion layer (the organic photoelectric conversion layer 60) includes the fourth photoelectric conversion section (the photoelectric conversion section 62) that photoelectrically converts light in the fourth wavelength region that is an infrared region.

Accordingly, it is possible to acquire, in the pixel region 3, information concerning the light of the RGB three colors and infrared light reflected from a target object.

The photodetection device 1 according to the embodiment further includes the another photoelectric conversion layer (the semiconductor layer 120) located on the side opposite to the light incident side of the photoelectric conversion layer (the organic photoelectric conversion layer 160) and including the plurality of other photoelectric conversion sections (the photodiodes PD4).

Accordingly, it is possible to acquire, in the pixel region 3, information concerning light in more wavelength regions reflected from a target object.

In the photodetection device 1 according to the embodiment, the photoelectric conversion layer (the organic photoelectric conversion layer 160) includes the first photoelectric conversion section (the photoelectric conversion section 1621), the second photoelectric conversion section (the photoelectric conversion section 1622), and the third photoelectric conversion section (the photoelectric conversion section 1623). The first photoelectric conversion section (the photoelectric conversion section 1621) photoelectrically converts light in the first wavelength region that is a visible region. The second photoelectric conversion section (the photoelectric conversion section 1622) photoelectrically converts light in the second wavelength region that is a visible region. The third photoelectric conversion section (the photoelectric conversion section 1623) photoelectrically converts light in the third wavelength region that is a visible region. The another photoelectric conversion layer (the semiconductor layer 120) includes the fourth photoelectric conversion section (the photodiode PD4) that photoelectrically converts light in the fourth wavelength region that is an infrared region.

Accordingly, it is possible to acquire, in the pixel region 3, information concerning the light of the RGB three colors and infrared light reflected from a target object.

The photodetection device 1 according to the embodiment includes the photoelectric conversion layer (the semiconductor layer 20), the color splitter layer 50, and the another photoelectric conversion layer (the organic photoelectric conversion layer 60). The photoelectric conversion layer (the semiconductor layer 20) includes the photoelectric conversion section group (the photodiode group PD1A or PD2A) including two photoelectric conversion sections (the photodiodes PD1 or PD2) capable of detecting a phase difference between incident light beams made incident thereon. The color splitter layer 50 is located further on the light incident side than the photoelectric conversion layer (the semiconductor layer 20) and has a meta-surface structure. The another photoelectric conversion layer (the organic photoelectric conversion layer 60) includes the another photoelectric conversion section group (the photoelectric conversion section group 62A) located further on the light incident side than the photoelectric conversion layer (the semiconductor layer 20) and configured by the two other photoelectric conversion sections (the photoelectric conversion sections 62) capable of detecting a phase difference between incident light beams made incident thereon. The dividing direction of the photoelectric conversion section group (the photodiode group PD1A or PD2A) the dividing direction of the another photoelectric conversion section group (the photoelectric conversion section group 62A) corresponding to the photoelectric conversion section group (the photodiode group PD1A or PD2A) intersect each other.

Accordingly, it is possible to measure the distance to a target object regardless of a texture direction and a color of the target object.

[Electronic equipment]

The photodetection device 1 as explained above can be applied to various kinds of electronic equipment such as an imaging system such as a digital still camera or a digital video camera, a mobile phone including an imaging function, or other equipment including an imaging function.

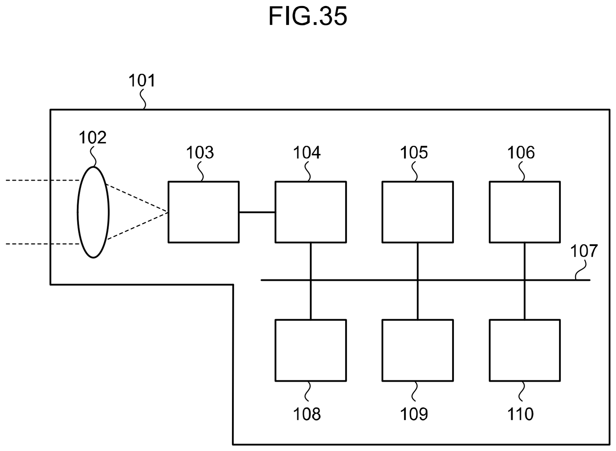

FIG. 35 is a block diagram illustrating a configuration example of electronic equipment 101.

As illustrated in FIG. 35, the electronic equipment 101 includes an optical system 102, a photodetection device 103, and a DSP (Digital Signal Processor) 104 and is configured by connecting the DSP 104, a display device 105, an operation system 106, a memory 108, a recording device 109, and a power supply system 110 via a bus 107 and is capable of capturing a still image and a moving image.

The optical system 102 includes one or a plurality of lenses, guides image light (incident light) from a subject to the photodetection device 103, and forms an image on a light receiving surface (a sensor section) of the photodetection device 103.

As the photodetection device 103, the photodetection device 1 of any one of the configuration examples explained above is applied. In the photodetection device 103, electrons are stored for a certain period according to an image formed on the light receiving surface via the optical system 102. Then, a signal corresponding to the electrons stored in the photodetection device 103 is supplied to the DSP 104.

The DSP 104 applies various kinds of signal processing on the signal from the photodetection device 103 to acquire an image and temporarily stores data of the image in the memory 108. The data of the image stored in the memory 108 is recorded in the recording device 109 or supplied to the display device 105 to display an image. The operation system 106 receives various kinds of operation by a user and supplies operation signals to blocks of the electronic equipment 101. The power supply system 110 supplies electric power necessary for driving the blocks of the electronic equipment 101.

In the electronic equipment 101 configured as explained above, it is possible to improve the detection sensitivity of a phase difference by applying, as the photodetection device 103, the photodetection device 1 explained above.

[Application example to a mobile body]

The technology according to the present disclosure (the present technology) can be applied to various products. For example, the technology according to the present disclosure may be implemented as a device mounted on a mobile body of any type such as an automobile, an electric vehicle, a hybrid electric vehicle, a motorcycle, a bicycle, a personal mobility, an airplane, a drone, a ship, and a robot.

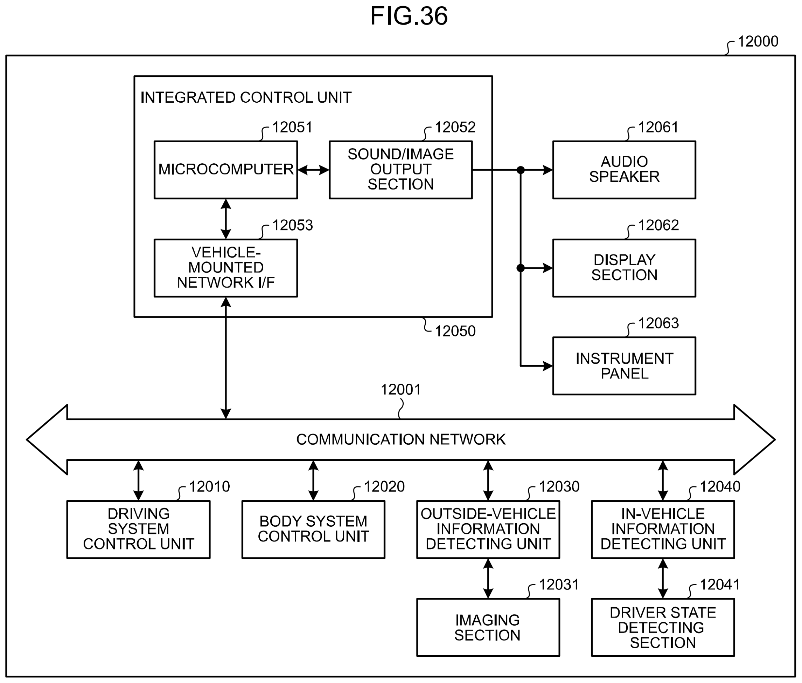

FIG. 36 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 36, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 36, an audio speaker 12061, a display section 12062, and an instrument panel 12063 are illustrated as the output device. The display section 12062 may, for example, include at least one of an on-board display and a head-up display.

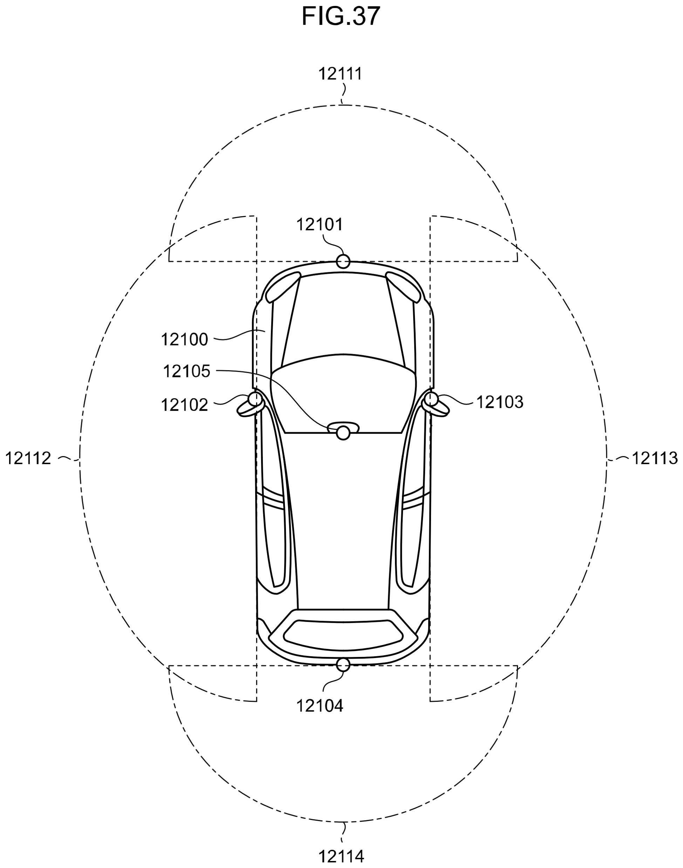

FIG. 37 is a diagram depicting an example of the installation position of the imaging section 12031.

In FIG. 37, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of a vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 37 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The example of the vehicle control system to which the technology according to the present disclosure can be applied is explained above. The technology according to the present disclosure can be applied to the imaging section 12031 among the configurations explained above. Specifically, the photodetection device 1 in FIG. 1 can be applied to the imaging section 12031. By applying the technology according to the present disclosure to the imaging section 12031, it is possible to improve the detection sensitivity of a phase difference in the imaging section 12031.

[Application example to an endoscopic surgery system]

The technology according to the present disclosure (the present technology) can be applied to various products. For example, the technology according to the present disclosure may be applied to an endoscopic surgery system.

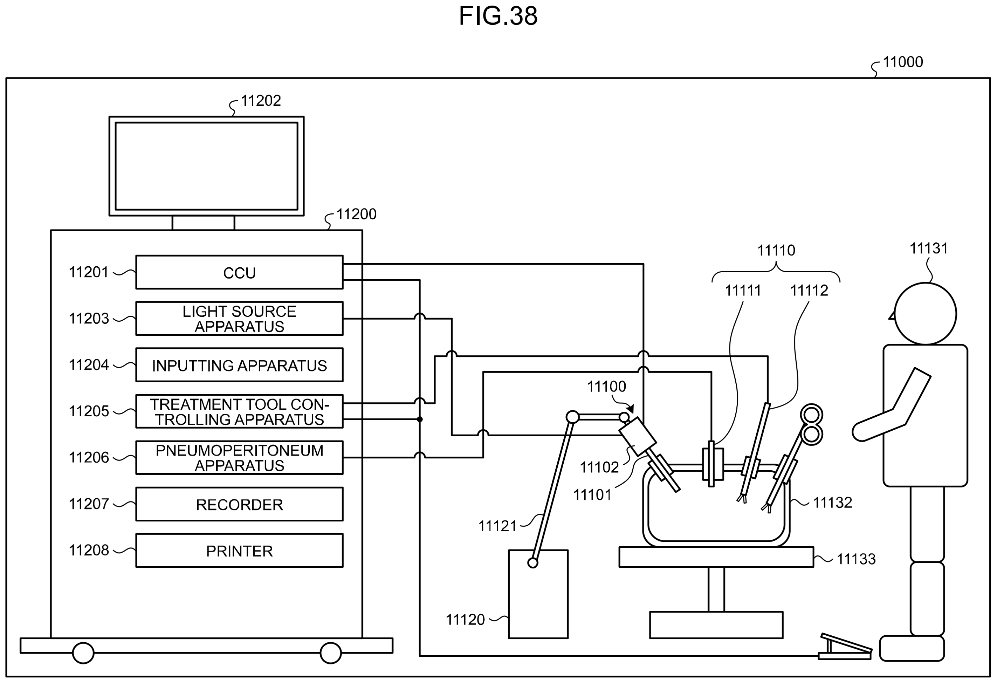

FIG. 38 a view depicting an example of a schematic configuration of an endoscopic surgery system to which the technology according to an embodiment of the present disclosure (present technology) can be applied.

In FIG. 38, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy treatment tool 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body lumen of the patient 11132, and a camera head 11102 connected to a proximal end of the lens barrel 11101. In the example depicted, the endoscope 11100 is depicted which includes as a hard mirror having the lens barrel 11101 of the hard type. However, the endoscope 11100 may otherwise be included as a soft mirror having the lens barrel 11101 of the soft type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body lumen of the patient 11132 through the objective lens. It is to be noted that the endoscope 11100 may be a direct view mirror or may be a perspective view mirror or a side view mirror.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy treatment tool 11112 for cautery or incision of a tissue, sealing of a blood vessel or the like. A pneumoperitoneum apparatus 11206 feeds gas into a body lumen of the patient 11132 through the pneumoperitoneum tube 11111 to inflate the body lumen in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

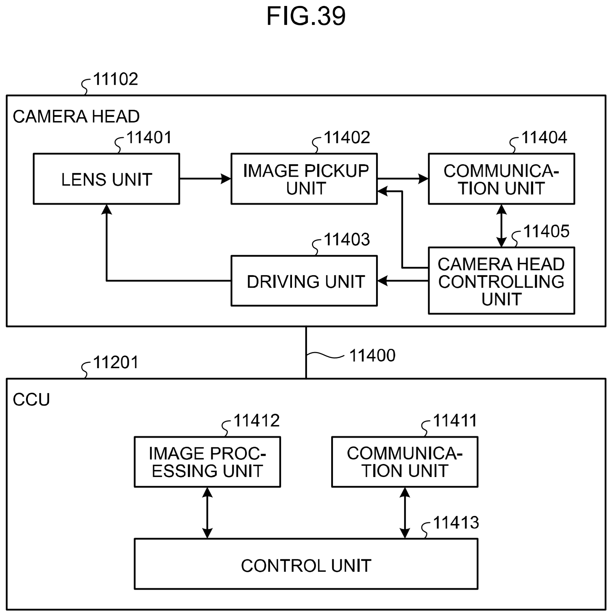

FIG. 39 is a block diagram depicting an example of a functional configuration of the camera head 11102 and the CCU 11201 depicted in FIG. 38.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy treatment tool 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technology according to the present disclosure can be applied is explained above. The technology according to the present disclosure can be applied to the image pickup unit 11402 of the camera head 11102 among the above-described configurations. Specifically, the photodetection device 1 in FIG. 1 can be applied to the image pickup unit 11402. By applying the technology according to the present disclosure to the image pickup unit 11402, since it is possible to improve the detection sensitivity of a phase difference in the image pickup unit 11402, the surgeon can securely check the surgical region.

Note that, here, the endoscopic surgery system is explained as an example. However, besides, the technology according to the present disclosure may be applied to, for example, a microscopic surgery system.

Although the embodiments of the present disclosure are explained above, the technical scope of the present disclosure is not limited to the embodiments per se. Various changes can be made without departing from the gist of the present disclosure. Components in different embodiments and modifications may be combined as appropriate.

The effects described in the present specification are only examples and are not limited. There may be other effects.

Note that the present technique can also take the following configurations.

(1) A photodetection device comprising:

a photoelectric conversion layer including a photoelectric conversion section group configured by a plurality of photoelectric conversion sections capable of detecting phase differences among incident light beams made incident thereon; and
a color splitter layer located further on a light incident side than the photoelectric conversion layer and having a meta-surface structure.

(2) The photodetection device according to the above (1), wherein
the photoelectric conversion section group is configured by a pair of the photoelectric conversion sections.
(3) The photodetection device according to the above (1), wherein
the photoelectric conversion section group is configured by a quartet of the photoelectric conversion sections.
(4) The photodetection device according to any one of the above (1) to (3), further comprising
another photoelectric conversion layer located further on the light incident side than the photoelectric conversion layer and including a plurality of other photoelectric conversion sections.
(5) The photodetection device according to the above (4), wherein
the another photoelectric conversion layer includes another photoelectric conversion section group configured by the plurality of other photoelectric conversion sections capable of detecting phase differences among incident light beams made incident thereon.
(6) The photodetection device according to the above (5), wherein
the another photoelectric conversion section group is configured by a pair of the other photoelectric conversion sections.
(7) The photodetection device according to the above (5), wherein
the another photoelectric conversion section group is configured by a quartet of the other photoelectric conversion sections.
(8) The photodetection device according to any one of the above (4) to (7), wherein
the another photoelectric conversion layer is located further on the light incident side than the color splitter layer.

(9) The photodetection device according to any one of the above (4) to (7), wherein
the color splitter layer is located further on the light incident side than the another photoelectric conversion layer.
(10) The photodetection device according to the above (8) or (9), wherein

the photoelectric conversion layer includes a first photoelectric conversion section that photoelectrically converts light in a first wavelength region that is a visible region, and a second photoelectric conversion section that photoelectrically converts light in a second wavelength region that is a visible region, and
the another photoelectric conversion layer includes a third photoelectric conversion section that photoelectrically converts light in a third wavelength region that is a visible region.

(11) The photodetection device according to the above (8), wherein

the photoelectric conversion layer includes a first photoelectric conversion section that photoelectrically converts light in a first wavelength region that is a visible region, a second photoelectric conversion section that photoelectrically converts light in a second wavelength region that is a visible region, and a third photoelectric conversion section that photoelectrically converts light in a third wavelength region that is a visible region, and
the another photoelectric conversion layer includes a fourth photoelectric conversion section that photoelectrically converts light in a fourth wavelength region that is an infrared region.

(12) The photodetection device according to the above (9), wherein

the photoelectric conversion layer includes a first photoelectric conversion section that photoelectrically converts light in a first wavelength region that is a visible region, a second photoelectric conversion section that photoelectrically converts light in a second wavelength region that is a visible region, and a third photoelectric conversion section that photoelectrically converts light in a third wavelength region that is a visible region, and
the another photoelectric conversion layer includes a fourth photoelectric conversion section that photoelectrically converts light in a fourth wavelength region that is an infrared region.

(13) The photodetection device according to any one of the above (1) to (3), further comprising
another photoelectric conversion layer located on a side opposite to the light incident side of the photoelectric conversion layer and including a plurality of other photoelectric conversion sections.
(14) The photodetection device according to the above (13), wherein

the photoelectric conversion layer includes a first photoelectric conversion section that photoelectrically converts light in a first wavelength region that is a visible region, a second photoelectric conversion section that photoelectrically converts light in a second wavelength region that is a visible region, and a third photoelectric conversion section that photoelectrically converts light in a third wavelength region that is a visible region, and
the another photoelectric conversion layer includes a fourth photoelectric conversion section that photoelectrically converts light in a fourth wavelength region that is an infrared region.

(15) A photodetection device comprising:

a photoelectric conversion layer including a photoelectric conversion section group configured by two photoelectric conversion sections capable of detecting a phase difference between incident light beams made incident thereon;
a color splitter layer located further on a light incident side than the photoelectric conversion layer and having a meta-surface structure; and
another photoelectric conversion layer located further on the light incident side than the photoelectric conversion layer and including another photoelectric conversion section group including two other photoelectric conversion sections capable of detecting a phase difference between incident light beams made incident thereon, wherein
a dividing direction of the photoelectric conversion section group and a dividing direction of the another photoelectric conversion section group corresponding to the photoelectric conversion section group intersect each other.

(16) The photodetection device according to the above (15), wherein
the another photoelectric conversion layer is located further on the light incident side than the color splitter layer.
(17) The photodetection device according to the above (15), wherein
the color splitter layer is located further on the light incident side than the another photoelectric conversion layer.

# EP 4 657 529 A1

(18) The photodetection device according to the above (16) or (17), wherein

the photoelectric conversion layer includes a first photoelectric conversion section that photoelectrically converts light in a first wavelength region that is a visible region, and a second photoelectric conversion section that photoelectrically converts light in a second wavelength region that is a visible region, and
the another photoelectric conversion layer includes a third photoelectric conversion section that photoelectrically converts light in a third wavelength region that is a visible region.

(19) The photodetection device according to the above (16) or (17), wherein

the photoelectric conversion layer includes a first photoelectric conversion section that photoelectrically converts light in a first wavelength region that is a visible region, a second photoelectric conversion section that photoelectrically converts light in a second wavelength region that is a visible region, and a third photoelectric conversion section that photoelectrically converts light in a third wavelength region that is a visible region, and
the another photoelectric conversion layer includes a fourth photoelectric conversion section that photoelectrically converts light in a fourth wavelength region that is an infrared region.

(20) The photodetection device according to the above (16) or (17), wherein

the photoelectric conversion layer includes a fourth photoelectric conversion section that photoelectrically converts light in a fourth wavelength region that is an infrared region, and
the another photoelectric conversion layer includes a first photoelectric conversion section that photoelectrically converts light in a first wavelength region that is a visible region, a second photoelectric conversion section that photoelectrically converts light in a second wavelength region that is a visible region, and a third photoelectric conversion section that photoelectrically converts light in a third wavelength region that is a visible region.

(21) Electronic equipment comprising:

a photodetection device;
an optical system that forms an image of incident light on the photodetection device; and
a signal processing circuit that executes predetermined processing on a signal output from the photodetection device, wherein
the photodetection device includes:

a photoelectric conversion layer including a photoelectric conversion section group configured by a plurality of photoelectric conversion sections capable of detecting phase differences among incident light beams made incident thereon; and
a color splitter layer located further on a light incident side than the photoelectric conversion layer and having a meta-surface structure.

(22) The electronic equipment according to the above (21), wherein
the photoelectric conversion section group is configured by a pair of the photoelectric conversion sections.
(23) The electronic equipment according to the above (21), wherein
the photoelectric conversion section group includes a quartet of the photoelectric conversion sections.
(24) The electronic equipment according to the above any one of (21) to (23), wherein
the photodetection device further includes another photoelectric conversion layer located further on the light incident side than the photoelectric conversion layer and including a plurality of other photoelectric conversion sections.
(25) The electronic equipment according to the above (24), wherein
the another photoelectric conversion layer includes another photoelectric conversion section group configured by a plurality of the other photoelectric conversion sections capable of detecting phase differences among incident light beams made incident thereon.
(26) The electronic equipment according to the above (25), wherein
the another photoelectric conversion section group is configured by a pair of the other photoelectric conversion sections.
(27) The electronic equipment according to the above (25), wherein
the another photoelectric conversion section group is configured by a quartet of the other photoelectric conversion sections.
(28) The electronic equipment according to the above any one of (24) to (27), wherein

the another photoelectric conversion layer is located further on the light incident side than the color splitter layer.

(29) The electronic equipment according to the above any one of (24) to (27), wherein
the color splitter layer is located further on the light incident side than the another photoelectric conversion layer.

(30) The electronic equipment according to the above (28) or (29), wherein

the photoelectric conversion layer includes a first photoelectric conversion section that photoelectrically converts light in a first wavelength region that is a visible region, and a second photoelectric conversion section that photoelectrically converts light in a second wavelength region that is a visible region, and
the another photoelectric conversion layer includes a third photoelectric conversion section that photoelectrically converts light in a third wavelength region that is a visible region.

(31) The electronic equipment according to the above (28), wherein

the photoelectric conversion layer includes a first photoelectric conversion section that photoelectrically converts light in a first wavelength region that is a visible region, a second photoelectric conversion section that photoelectrically converts light in a second wavelength region that is a visible region, and a third photoelectric conversion section that photoelectrically converts light in a third wavelength region that is a visible region, and
the another photoelectric conversion layer includes a fourth photoelectric conversion section that photoelectrically converts light in a fourth wavelength region that is an infrared region.

(32) The electronic equipment according to the above (29), wherein

the photoelectric conversion layer includes a first photoelectric conversion section that photoelectrically converts light in a first wavelength region that is a visible region, a second photoelectric conversion section that photoelectrically converts light in a second wavelength region that is a visible region, and a third photoelectric conversion section that photoelectrically converts light in a third wavelength region that is a visible region, and
the another photoelectric conversion layer includes a fourth photoelectric conversion section that photoelectrically converts light in a fourth wavelength region that is an infrared region.

(33) The electronic equipment according to the above any one of (21) to (23), wherein
the photodetection device further includes another photoelectric conversion layer located on a side opposite to the light incident side of the photoelectric conversion layer and including a plurality of other photoelectric conversion sections.

(34) The electronic equipment according to the above (33), wherein

the photoelectric conversion layer includes a first photoelectric conversion section that photoelectrically converts light in a first wavelength region that is a visible region, a second photoelectric conversion section that photoelectrically converts light in a second wavelength region that is a visible region, and a third photoelectric conversion section that photoelectrically converts light in a third wavelength region that is a visible region, and
the another photoelectric conversion layer includes a fourth photoelectric conversion section that photoelectrically converts light in a fourth wavelength region that is an infrared region.

(35) Electronic equipment comprising:

a photodetection device;
an optical system that forms an image of incident light on the photodetection device; and
a signal processing circuit that executes predetermined processing on a signal output from the photodetection device, wherein
the photodetection device includes:

a photoelectric conversion layer including a photoelectric conversion section group configured by two photoelectric conversion sections capable of detecting a phase difference between incident light beams made incident thereon;
a color splitter layer located further on a light incident side than the photoelectric conversion layer and having a meta-surface structure; and
another photoelectric conversion layer located further on the light incident side than the photoelectric conversion layer and including another photoelectric conversion section group configured by two other photoelectric conversion sections capable of detecting a phase difference between incident light beans made incident thereon, and

a dividing direction of the photoelectric conversion section group and a dividing direction of the another photoelectric conversion section group corresponding to the photoelectric conversion section group intersect each other.

(36) The electronic equipment according to the above (35), wherein
the another photoelectric conversion layer is located further on the light incident side than the color splitter layer.
(37) The electronic equipment according to the above (35), wherein
the color splitter layer is located further on the light incident side of the another photoelectric conversion layer.
(38) The electronic equipment according to the above (36) or (37), wherein

the photoelectric conversion layer includes a first photoelectric conversion section that photoelectrically converts light in a first wavelength region that is a visible region, and a second photoelectric conversion section that photoelectrically converts light in a second wavelength region that is a visible region, and
the another photoelectric conversion layer includes a third photoelectric conversion section that photoelectrically converts light in a third wavelength region that is a visible region.

(39) The electronic equipment according to the above (36) or (37), wherein

the photoelectric conversion layer includes a first photoelectric conversion section that photoelectrically converts light in a first wavelength region that is a visible region, a second photoelectric conversion section that photoelectrically converts light in a second wavelength region that is a visible region, and a third photoelectric conversion section that photoelectrically converts light in a third wavelength region that is a visible region, and
the another photoelectric conversion layer includes a fourth photoelectric conversion section that photoelectrically converts light in a fourth wavelength region that is an infrared region.

Reference Signs List

1 PHOTODETECTION DEVICE
2 PIXEL
3 PIXEL REGION
20 SEMICONDUCTOR LAYER (EXAMPLE OF PHOTOELECTRIC CONVERSION LAYER)
50 COLOR SPLITTER LAYER
60 ORGANIC PHOTOELECTRIC CONVERSION LAYER (EXAMPLE OF ANOTHER PHOTOELECTRIC CONVERSION LAYER)
62 PHOTOELECTRIC CONVERSION SECTION (EXAMPLE OF ANOTHER PHOTOELECTRIC CONVERSION SECTION AND FOURTH PHOTOELECTRIC CONVERSION SECTION)
62A PHOTOELECTRIC CONVERSION SECTION GROUP (EXAMPLE OF ANOTHER PHOTOELECTRIC CONVERSION SECTION GROUP)
101 ELECTRONIC EQUIPMENT
120 SEMICONDUCTOR LAYER (EXAMPLE OF ANOTHER PHOTOELECTRIC CONVERSION LAYER)
160 ORGANIC PHOTOELECTRIC CONVERSION LAYER (EXAMPLE OF PHOTOELECTRIC CONVERSION LAYER)
162 PHOTOELECTRIC CONVERSION SECTION (EXAMPLE OF PHOTOELECTRIC CONVERSION SECTION)
1621 PHOTOELECTRIC CONVERSION SECTION (EXAMPLE OF PHOTOELECTRIC CONVERSION SECTION AND FIRST PHOTOELECTRIC CONVERSION SECTION)
1622 PHOTOELECTRIC CONVERSION SECTION (EXAMPLE OF PHOTOELECTRIC CONVERSION SECTION AND SECOND PHOTOELECTRIC CONVERSION SECTION)
1623 PHOTOELECTRIC CONVERSION SECTION (EXAMPLE OF PHOTOELECTRIC CONVERSION SECTION AND THIRD PHOTOELECTRIC CONVERSION SECTION)
1621A to 1623A PHOTOELECTRIC CONVERSION SECTION GROUP (EXAMPLE OF PHOTOELECTRIC CONVERSION SECTION GROUP)
CS1, CS2, CS3 COLOR SPLITTER
PD1 PHOTODIODE (EXAMPLE OF PHOTOELECTRIC CONVERSION SECTION AND FIRST PHOTOELECTRIC CONVERSION SECTION)
PD2 PHOTODIODE (EXAMPLE OF PHOTOELECTRIC CONVERSION SECTION AND SECOND PHOTOELECTRIC CONVERSION SECTION)
PD3 PHOTODIODE (EXAMPLE OF PHOTOELECTRIC CONVERSION SECTION AND THIRD PHOTOELECTRIC CONVERSION SECTION)
PD4 PHOTODIODE (EXAMPLE OF ANOTHER PHOTOELECTRIC CONVERSION SECTION AND FOURTH PHOTOELECTRIC CONVERSION SECTION)
PD1A to PD3A PHOTODIODE GROUP (EXAMPLE OF PHOTOELECTRIC CONVERSION SECTION GROUP)
PD4A PHOTODIODE GROUP (EXAMPLE OF ANOTHER PHOTOELECTRIC CONVERSION SECTION GROUP)

**Claims**

1. A photodetection device comprising:

   a photoelectric conversion layer including a photoelectric conversion section group configured by a plurality of photoelectric conversion sections capable of detecting phase differences among incident light beams made incident thereon; and
   a color splitter layer located further on a light incident side than the photoelectric conversion layer and having a meta-surface structure.

2. The photodetection device according to claim 1, wherein
   the photoelectric conversion section group is configured by a pair of the photoelectric conversion sections.

3. The photodetection device according to claim 1, wherein
   the photoelectric conversion section group is configured by a quartet of the photoelectric conversion sections.

4. The photodetection device according to claim 1, further comprising
   another photoelectric conversion layer located further on the light incident side than the photoelectric conversion layer and including a plurality of other photoelectric conversion sections.

5. The photodetection device according to claim 4, wherein
   the another photoelectric conversion layer includes another photoelectric conversion section group configured by the plurality of other photoelectric conversion sections capable of detecting phase differences among incident light beams made incident thereon.

6. The photodetection device according to claim 5, wherein
   the another photoelectric conversion section group is configured by a pair of the other photoelectric conversion sections.

7. The photodetection device according to claim 5, wherein
   the another photoelectric conversion section group is configured by a quartet of the other photoelectric conversion sections.

8. The photodetection device according to claim 4, wherein
   the another photoelectric conversion layer is located further on the light incident side than the color splitter layer.

9. The photodetection device according to claim 4, wherein
   the color splitter layer is located further on the light incident side than the another photoelectric conversion layer.

10. The photodetection device according to claim 8, wherein

    the photoelectric conversion layer includes a first photoelectric conversion section that photoelectrically converts light in a first wavelength region that is a visible region, and a second photoelectric conversion section that photoelectrically converts light in a second wavelength region that is a visible region, and
    the another photoelectric conversion layer includes a third photoelectric conversion section that photoelectrically converts light in a third wavelength region that is a visible region.

11. The photodetection device according to claim 8, wherein

the photoelectric conversion layer includes a first photoelectric conversion section that photoelectrically converts light in a first wavelength region that is a visible region, a second photoelectric conversion section that photoelectrically converts light in a second wavelength region that is a visible region, and a third photoelectric conversion section that photoelectrically converts light in a third wavelength region that is a visible region, and the another photoelectric conversion layer includes a fourth photoelectric conversion section that photoelectrically converts light in a fourth wavelength region that is an infrared region.

12. The photodetection device according to claim 9, wherein

the photoelectric conversion layer includes a first photoelectric conversion section that photoelectrically converts light in a first wavelength region that is a visible region, a second photoelectric conversion section that photoelectrically converts light in a second wavelength region that is a visible region, and a third photoelectric conversion section that photoelectrically converts light in a third wavelength region that is a visible region, and the another photoelectric conversion layer includes a fourth photoelectric conversion section that photoelectrically converts light in a fourth wavelength region that is an infrared region.

13. The photodetection device according to claim 1, further comprising
another photoelectric conversion layer located on a side opposite to the light incident side of the photoelectric conversion layer and including a plurality of other photoelectric conversion sections.

14. The photodetection device according to claim 13, wherein

the photoelectric conversion layer includes a first photoelectric conversion section that photoelectrically converts light in a first wavelength region that is a visible region, a second photoelectric conversion section that photoelectrically converts light in a second wavelength region that is a visible region, and a third photoelectric conversion section that photoelectrically converts light in a third wavelength region that is a visible region, and the another photoelectric conversion layer includes a fourth photoelectric conversion section that photoelectrically converts light in a fourth wavelength region that is an infrared region.

15. A photodetection device comprising:

a photoelectric conversion layer including a photoelectric conversion section group configured by two photoelectric conversion sections capable of detecting a phase difference between incident light beams made incident thereon;
a color splitter layer located further on a light incident side than the photoelectric conversion layer and having a meta-surface structure; and
another photoelectric conversion layer located further on the light incident side than the photoelectric conversion layer and including another photoelectric conversion section group including two other photoelectric conversion sections capable of detecting a phase difference between incident light beams made incident thereon, wherein
a dividing direction of the photoelectric conversion section group and a dividing direction of the another photoelectric conversion section group corresponding to the photoelectric conversion section group intersect each other.

16. Electronic equipment comprising:

a photodetection device;
an optical system that forms an image of incident light on the photodetection device; and
a signal processing circuit that executes predetermined processing on a signal output from the photodetection device, wherein
the photodetection device includes:

a photoelectric conversion layer including a photoelectric conversion section group configured by a plurality of photoelectric conversion sections capable of detecting phase differences among incident light beams made incident thereon; and
a color splitter layer located further on a light incident side than the photoelectric conversion layer and having a meta-surface structure.

# FIG.1

1 PHOTODETECTION DEVICE

# FIG.2

# FIG.3

(a)    3   2   70   71

(b)    60   62(G)

(c)    50   CS1   CS2

(d)    20   PD1   PD1   PD2   PD2   PD1A(R)   PD2A(B)

FIG.4

# FIG.5

# FIG.6

# FIG.7

# FIG.8

# FIG.9

# FIG.10

# FIG.11

# FIG.12

(a)

70

71

(b)

60

62
62A(G)
62

(c)

50

CS1

CS2

(d)

20

PD1 PD1

PD2 PD2

PD1A(R)

PD2A(B)

# FIG.13

# FIG.14

# FIG.15

# FIG.16

# FIG.17

3

(a)

70

71

(b)

60

62(IR)

(c)

50

CS1

CS3

CS2

(d)

20

PD1

PD1 } PD1A(R)

PD3  PD3

PD2  PD2

PD3A(G)

PD2A(B)

# FIG.18

(a)

70

71

(b)

60

62(IR)

(c)

50

CS1

CS3

CS2

(d)

20

24

PD2

PD2

PD2A(B)

PD1(R)

PD3(G)    24    PD2(B)

3

# FIG.19

# FIG.20

# FIG.21

# FIG.22

# FIG.23

# FIG.24

3

(a)

70

71

(b)

60

62
62A(IR)
62

(c)

50

CS1

CS3

CS2

(d)

20

PD1
PD1A(R)
PD1

PD3 PD3

PD2 PD2

PD3A(G)

PD2A(B)

# FIG.25

(a)

70

71

(b)

60

62(IR)

62

62 } 62A(IR)

64

(c)

50

CS1

CS3

CS2

(d)

20

PD1 } PD1A(R)

PD1

PD3   PD3

PD2   PD2

PD3A(G)

PD2A(B)

# FIG.26

(a)

70

71A(71)

(b)

60

62
62
62
62

62A(IR)

(c)

50

CS1
CS2
CS3

(d)

20

PD1
PD1

PD1A(R)

PD3  PD3

PD3A(G)

PD2  PD2

PD2A(B)

# FIG.27

# FIG.28

# FIG.29

# FIG.30

# FIG.31

3

(a)

70

71

(b)

60

62
62 } 62A(G)

(c)

50

CS1

CS2

(d)

20

PD1 PD1

PD2 PD2

PD1A(R)

PD2A(B)

# FIG.32

3

(a) 70
71

(b) 60
62
62A(G)
62

(c) 50
CS1 CS2

(d) 20
A

PD1 PD1 PD2 PD2
PD1A(R) PD2A(B)

# FIG.33

# FIG.34

# FIG.35

## FIG.36

INTEGRATED CONTROL UNIT

MICROCOMPUTER 12051

SOUND/IMAGE OUTPUT SECTION 12052

VEHICLE-MOUNTED NETWORK I/F 12053

12050

AUDIO SPEAKER 12061

DISPLAY SECTION 12062

INSTRUMENT PANEL 12063

12000

12001

COMMUNICATION NETWORK

DRIVING SYSTEM CONTROL UNIT 12010

BODY SYSTEM CONTROL UNIT 12020

OUTSIDE-VEHICLE INFORMATION DETECTING UNIT 12030

IN-VEHICLE INFORMATION DETECTING UNIT 12040

IMAGING SECTION 12031

DRIVER STATE DETECTING SECTION 12041

EP 4 657 529 A1

# FIG.37

# FIG.38

CCU — 11201
LIGHT SOURCE APPARATUS — 11203
INPUTTING APPARATUS — 11204
TREATMENT TOOL CONTROLLING APPARATUS — 11205
PNEUMOPERITONEUM APPARATUS — 11206
RECORDER — 11207
PRINTER — 11208

11202
11200
11000
11110
11111  11112
11131
11100
11102
11101
11121
11132
11120
11133

EP 4 657 529 A1

# FIG.39

## INTERNATIONAL SEARCH REPORT

| International application No. |
|---|
| **PCT/JP2023/044598** |

**A. CLASSIFICATION OF SUBJECT MATTER**

*H01L 27/146*(2006.01)i; *H04N 25/70*(2023.01)i; *H04N 25/704*(2023.01)i
FI: H01L27/146 D; H01L27/146 A; H01L27/146 E; H04N25/70; H04N25/704

According to International Patent Classification (IPC) or to both national classification and IPC

**B. FIELDS SEARCHED**

Minimum documentation searched (classification system followed by classification symbols)

H01L27/146; H04N25/70; H04N25/704

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2021-067691 A (SAMSUNG ELECTRONICS CO., LTD.) 30 April 2021 (2021-04-30) paragraphs [0031]-[0033], [0113]-[0117], fig. 2-3, 25-36 | 1-6, 13-16 |
| A | entire text, all drawings | 7-12 |
| Y | JP 2019-184986 A (NIPPON TELEGRAPH AND TELEPHONE CORPORATION) 24 October 2019 (2019-10-24) paragraph [0016] | 1-6, 13-16 |
| Y | WO 2016/098640 A1 (SONY CORPORATION) 23 June 2016 (2016-06-23) paragraphs [0002], [0041], [0085], fig. 3-4, 26 | 1-6, 13-16 |
| Y | JP 2018-160779 A (CANON KABUSHIKI KAISHA) 11 October 2018 (2018-10-11) paragraphs [0020], [0039]-[0067], fig. 6-10 | 4-6, 15 |
| A | entire text, all drawings | 7-12 |

✓ Further documents are listed in the continuation of Box C.    ✓ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **06 February 2024** | **20 February 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

## INTERNATIONAL SEARCH REPORT

| International application No. |
|---|
| **PCT/JP2023/044598** |

### C. DOCUMENTS CONSIDERED TO BE RELEVANT

| Category* | Citation of document, with indication, where appropriate, of the relevant passages | Relevant to claim No. |
|---|---|---|
| Y | US 2016/0254300 A1 (DUAL APERTURE INTERNATIONAL CO., LTD.) 01 September 2016 (2016-09-01) <br> paragraphs [0028]-[0029], fig. 9-10 | 13-14 |
| P, X | WO 2023/013554 A1 (SONY SEMICONDUCTOR SOLUTIONS CORP.) 09 February 2023 (2023-02-09) <br> paragraphs [0089]-[0103], [0125], fig. 22-26 | 1-3, 16 |

Form PCT/ISA/210 (second sheet) (July 2022)

**INTERNATIONAL SEARCH REPORT**
Information on patent family members

International application No.

**PCT/JP2023/044598**

| Patent document cited in search report | | | Publication date (day/month/year) | Patent family member(s) | | Publication date (day/month/year) |
|---|---|---|---|---|---|---|
| JP | 2021-067691 | A | 30 April 2021 | US 2021/0126030 A1<br>paragraphs [0033]-[0034],<br>[0148]-[0152], fig. 2-3, 25-36<br>KR 10-2021-0048400 A<br>CN 112701132 A | | |
| JP | 2019-184986 | A | 24 October 2019 | US 2020/0266230 A1<br>paragraph [0016]<br>KR 10-2020-0029572 A<br>CN 111095561 A | | |
| WO | 2016/098640 | A1 | 23 June 2016 | US 2017/0366770 A1<br>paragraphs [0003], [0095],<br>[0147], fig. 3-4, 26<br>CN 107004685 A<br>KR 10-2017-0098809 A | | |
| JP | 2018-160779 | A | 11 October 2018 | (Family: none) | | |
| US | 2016/0254300 | A1 | 01 September 2016 | (Family: none) | | |
| WO | 2023/013554 | A1 | 09 February 2023 | (Family: none) | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017157801 A